(19)

Europäisches
Patentamt
European
Patent Office
Office européen
des brevets

(11) **EP 4 312 474 A1**

(12) **EUROPEAN PATENT APPLICATION**

(43) Date of publication:
**31.01.2024 Bulletin 2024/05**

(21) Application number: **23187235.9**

(22) Date of filing: **24.07.2023**

(51) International Patent Classification (IPC):
**H05K 7/14** (2006.01)     **H05K 9/00** (2006.01)
**H02M 7/00** (2006.01)

(52) Cooperative Patent Classification (CPC):
**H05K 7/1432; H02M 1/007; H02M 1/0074;
H02M 3/003; H02M 3/285; H02M 7/003;
H02M 7/02; H05K 9/0045**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **26.07.2022   CN 202210884802
27.03.2023   CN 202310309186**

(71) Applicant: **Delta Electronics (Shanghai) Co., Ltd.
Shanghai 201209 (CN)**

(72) Inventors:
• **MA, Peng
Shanghai, 201209 (CN)**
• **XIE, Yicong
Shanghai, 201209 (CN)**
• **ZHANG, Weiqiang
Shanghai, 201209 (CN)**
• **LIU, Guoli
Shanghai, 201209 (CN)**
• **LAN, Lin
Shanghai, 201209 (CN)**

(74) Representative: **SSM Sandmair
Patentanwälte Rechtsanwalt
Partnerschaft mbB
Joseph-Wild-Straße 20
81829 München (DE)**

(54)   **SHIELDED INSULATING SHELL AND ELECTRONIC DEVICE**

(57)   The present disclosure discloses a shielded insulating shell (100) and an electronic device. The shielded insulating shell (100) includes a shell body (SB) provided with a first cavity (R1), with an inner shielding layer (IS) near the first cavity (R1) and an outer shielding layer (OS) far away from the first cavity (R1) being formed on the shell body (SB); a first structure (ST1) formed on the first cavity (R1), and formed by assembling to comprise at least a first shielding layer, a first insulating layer, a first air gap layer, a second insulating layer, and a second shielding layer arranged sequentially from an inner side to an outer side of the first cavity (R1); and an assembling gap (AG) formed on the first structure (ST1), which cooperates with the first air gap layer to form a creepage path on the first structure (ST1) that extends from the inner shielding layer (IS) to the outer shielding layer (OS).

**FIG. 1**

**Description**

BACKGROUND ART

1. Field of the Disclosure

The present disclosure relates to power electronic technology, in particular to a shielded insulating shell and an electronic device with the same.

2. Related Art

The solid state transformer (SST), with its advantages of high efficiency and modularization, is the development direction of power supply for data centers and charging piles in the future. The SST system may be composed of a plurality of power modules in cascade. Moreover, medium voltage insulation requirements of the whole SST system may be divided into three categories: phase-to-phase insulation and shell-to-shell insulation; insulation between high and low voltage module circuits and insulation between the primary side and the secondary side of the high frequency transformer; insulation between the medium voltage (MV) side of the auxiliary power supply and the safety extra low voltage (SELV) side of the electric supply.

The traditional solution is to insulate the three positions separately. For example, the phase-to-phase insulation and shell-to-shell insulation are mainly isolated by insulating plates or shielded insulating shells. The insulation between the primary side and the secondary side of the high frequency transformer is generally used for isolation by insulation and encapsulation on the high voltage coil, while the auxiliary power supply is insulated in a complex form of high voltage silicone wires and air. Such a solution with separated designs of insulation will increase the number of components and parts in the system and increase the complexity of the system.

At present, there are still some solutions to share a shielded insulating shell for insulation and isolation in the three positions, so as to simplify the complexity of the system and reduce the volume of the device and the weight of the module. For example, the existing solution adopts integrated cylinder insulating shell or detachable embedded mesh insulating shell for insulation and isolation, but these insulating shells have many inconveniences, such as confined installation and operation space in the module cabin, requiring complex positioning fixture, large number of shell components, and complex structure. Moreover, the air gap of the existing insulating shell is disposed outside the high and low voltage shielding layers, and the high and low voltage shielding layers are close to each other. The electric field stress in the air near the edge of the high voltage shielding layers is concentrated, and the maximum electric field may reach 3.7kV/mm. Therefore, the existing insulating shell also has low partial discharge resistance and poor electrical performance yield.

SUMMARY OF THE INVENTION

The present disclosure aims to provide a shielded insulating shell and an electronic device, which may effectively solve at least a defect of the prior art.

In order to achieve the above purpose, the present disclosure provides a shielded insulating shell, including a shell body provided with a first cavity, with an inner shielding layer near the first cavity and an outer shielding layer far away from the first cavity being formed on the shell body; a first structure formed on the first cavity, and formed by assembling to include at least a first shielding layer, a first insulating layer, a first air gap layer, a second insulating layer, and a second shielding layer arranged sequentially from an inner side to an outer side of the first cavity; and an assembling gap formed on the first structure, which cooperates with the first air gap layer to form a creepage path on the first structure that extends from the inner shielding layer to the outer shielding layer.

In an embodiment of the present disclosure, the shell body may include a first shell and a second shell, wherein the first shell includes a first plate-like structure and at least two first bosses respectively disposed on two opposite sides of the first plate-like structure and extending along a first direction; the second shell includes a second plate-like structure and at least two second bosses respectively disposed on two opposite sides of the second plate-like structure and extending along the first direction; the first and second shells are fitted and connected to form a first cavity through the at least two first bosses and the at least two second bosses, wherein an upper wall of the first cavity is formed by the first plate-like structure and includes two upper wall shielding layers and an upper wall insulating layer between the two upper wall shielding layers, and a lower wall of the first cavity is formed by the second plate-like structure and includes two lower wall shielding layers and a lower wall insulating layer between the two lower wall shielding layers; two side walls of the first cavity are disposed between the upper wall and the lower wall and are respectively formed by the first boss and the second boss which are correspondingly fitted and connected, each of the side walls including, from inside to outside, a first side wall shielding layer, a first side wall insulating layer, a first side wall air gap layer, a second side wall insulating layer and a second side wall shielding layer; an inner upper wall shielding layer of the two upper wall shielding layers that is disposed on the inner side, an inner lower wall shielding layer of the two lower wall shielding layers that is disposed on the inner side, and the first side wall shielding layer form the inner wall shielding layer correspondingly; and an outer upper wall shielding layer of the two upper wall shielding layers that is disposed on the outer side, an outer lower wall shielding layer of the two lower wall shielding layers that is disposed on the outer side, and the second side wall shielding layer form the outer shielding layer correspondingly.

In an embodiment of the present disclosure, at least a boss interface flush structure may be formed formed at a position where the at least two first bosses and the at least two second bosses are fitted and connected to each other; each side or one side of the two sides of the first shell includes two first bosses, and each side or one side of the two sides of the second shell includes two second bosses, whereof the two first bosses and the two second bosses on each side or the one side are jointed to form two boss interfaces which are disposed at the same height and between a top surface and a bottom surface of the first side wall air gap layer

In an embodiment of the present disclosure, the two boss interfaces may be centrally disposed on a middle plane between the top surface and the bottom surface of the first side wall air gap layer.

In an embodiment of the present disclosure, at least a boss interface staggered structure may be formed at a position where the at least two first bosses and the at least two second bosses are fitted and connected to each other; wherein, each side or one side of the two sides of the first shell includes one first boss, and each side or one side of the two sides of the second shell includes one second boss, wherein an end of the first boss is jointed with the second plate-like structure of the second shell to form a first boss interface, and an end of the second boss is jointed with the first plate-like structure of the first shell to form a second boss interface, wherein the first boss interface and the second boss interface are not at the same height; or, each side or one side of the two sides of the first shell includes one first boss, and each side or one side of the two sides of the second shell includes two second bosses, wherein an end of one of the two second bosses is jointed with an end of the first boss to form a first boss interface, and an end of the other one of the two second bosses is jointed with the first plate-like structure of the first shell to form a second boss interface, wherein the first boss interface and the second boss interface are not at the same height; or, each side or one side of the two sides of the first shell includes two first bosses, and each side or one side of the two sides of the second shell includes one second boss, wherein an end of one of the two first bosses is jointed with an end of the second boss to form a first boss interface, and an end of the other one of the two first bosses is jointed with the second plate-like structure of the second shell to form a second boss interface, wherein the first boss interface and the second boss interface are not at the same height; or, each side or one side of the two sides of the first shell includes two first bosses, and each side or one side of the two sides of the second shell includes two second bosses, wherein the ends of the two first bosses and the ends of the two second bosses are jointed correspondingly to form two boss interfaces, wherein the two boss interfaces are not at the same height.

In an embodiment of the present disclosure, at least a boss encapsulation structure may be formed at a position where the at least two first bosses and the at least two second bosses are fitted and connected to each other, wherein, each side or one side of the two sides of the first shell includes two first bosses, and each side or one side of the two sides of the second shell includes two second bosses, wherein an end of an inner first boss of the two first bosses that is disposed on an inner side is jointed with an end of an inner second boss of the two second bosses that is disposed on an inner side, and an end of an outer second boss of the two second bosses that is disposed on an outer side is jointed with the first plate-like structure of the first shell, wherein an outer first boss of the two first bosses that is disposed on an outer side encapsulates from the outside the outer second boss of the second shell; or, each side or one side of the two sides of the first shell includes two first bosses, and each side or one side of the two sides of the second shell includes one second boss, wherein an end of the second boss is jointed with the first plate-like structure of the first shell, and an end of the inner first boss of the two first bosses that is disposed on an inner side is jointed with the second plate-like structure of the second shell, wherein the outer first boss of the two first bosses that is disposed on an outer side encapsulates from the outside the second boss of the second shell; or, each side or one side of the two sides of the first shell includes two first bosses, and each side or one side of the two sides of the second shell includes two second bosses, wherein an end of the inner first boss of the two first bosses that is disposed on an inner side is jointed with an end of the inner second boss of the two second bosses that is disposed on an inner side, and an end of the outer first boss of the two first bosses that is disposed on an outer side is jointed with the second plate-like structure of the second shell, wherein the outer second boss of the two second bosses that is disposed on an outer side encapsulates from the outside the outer first boss of the first shell; or, each side or one side of the two sides of the first shell includes one first boss, and each side or one side of the two sides of the second shell includes two second bosses, wherein an end of the inner second boss of the two second bosses disposed on inner side is jointed with the first plate-like structure of the first shell, and an end of the first boss is jointed with the second plate-like structure of the second shell, wherein the outer second boss of the two second bosses that is disposed on an outer side encapsulates from the outside the first boss of the first shell.

In an embodiment of the present disclosure, each of the side walls of the first cavity may include at least one of the first bosses and at least one of the second bosses, wherein one of the first boss and the second boss that is disposed on the innermost side is set as an innermost boss, wherein, the first side wall shielding layer is disposed on an inner surface of the innermost boss; or the first side wall shielding layer is disposed inside the innermost boss.

In an embodiment of the present disclosure, an independent insulating layer may be further provided in the first side wall air gap layer; or, when the first side wall shielding layer is disposed inside the innermost boss, an independent insulating layer is provided between the innermost boss and a high voltage module which is accommodated in the first cavity.

In an embodiment of the present disclosure, a further upper wall insulating layer may be formed on an inner surface of the inner upper wall shielding layer; and/or, a further lower wall insulating layer may be formed on the inner surface of the inner lower wall shielding layer.

In an embodiment of the present disclosure, an upper side and/or a lower side of at least part of the second plate-like structure of the second shell may form a concave portion for disposing a primary magnetic core and a secondary magnetic core of a transformer, wherein the two lower wall shielding layers corresponding to the concave portion are semiconductive layers.

In an embodiment of the present disclosure, a lower side of the lower wall of the first cavity may be further provided with at least two third bosses, wherein the at least two third bosses and the lower wall of the first cavity form a second cavity; and the first cavity is used to accommodate a high voltage module, and the second cavity is used to accommodate a lower voltage module.

In an embodiment of the present disclosure, the shielded insulating shell may further include a high voltage shielding layer and a low voltage shielding layer, wherein the position of the high voltage shielding layer includes all surfaces immediately adjacent to the high voltage module, and the position of the low voltage shielding layer includes all surfaces immediately adjacent to a low voltage module.

In an embodiment of the present disclosure, shielding layer materials of the two upper wall shielding layers, the two lower wall shielding layers, the first side wall shielding layer, and the second side wall shielding layer may be metal materials or semiconductive materials, with a surface resistance greater than 500kohm; and/or, shielding layers of the two upper wall shielding layers, the two lower wall shielding layers, the first side wall shielding layer, and the second side wall shielding layer may include a galvanized coating layer, a sheet metal layer or a semiconductive layer; and/or, the shielding layers of the two upper wall shielding layers, the two lower wall shielding layers, the first side wall shielding layer, and the second side wall shielding layer are perforated plate-like structures or non-perforated plate-like structures.

In an embodiment of the present disclosure, insulating materials of the upper wall insulating layer, the lower wall insulating layer, the first side wall insulating layer and the second side wall insulating layer may be epoxy resin, polyurethane or silicone rubber; and/or, a medium in the first side wall air gap layer may be air, sulfur hexafluoride gas or insulating oil; and/or, the shielded insulating shell may be of a detachable structure in which the first shell and the second shell are connected and assembled through a detachable connector.

In an embodiment of the present disclosure, the top surface of the first side wall air gap layer may be a part of the first shell, and the bottom surface of the first side wall air gap layer may be a part of the second shell.

In an embodiment of the present disclosure, the first shell may further include at least a first intermediate boss disposed between the at least two first bosses; and/or, the second shell may further include at least a second intermediate boss disposed between the at least two second bosses, wherein the at least a first intermediate boss and/or the at least a second intermediate boss form at least a first intermediate isolation portion which separates the first cavity into at least two first sub-cavities.

In an embodiment of the present disclosure, the at least a first intermediate isolation portion may include a first isolation structure which is formed by disposing one first intermediate boss to be opposite to one second intermediate boss, wherein the first intermediate boss and the second intermediate boss for forming the first isolation structure being in contact with each other or separated from each other; and/or, the at least a first intermediate isolation portion may include a second isolation structure, which is any one of, or a combination of some of, an intermediate boss interface flush structure, an intermediate boss interface staggered structure and an intermediate boss encapsulation structure; for the intermediate boss interface flush structure, two intermediate boss interfaces may be formed by disposing two first intermediate bosses to be opposite to two second intermediate bosses, wherein the two intermediate boss interfaces are disposed at the same height; for the intermediate boss interface staggered structure, the intermediate boss interface staggered structure may be formed by one first intermediate boss and one second intermediate boss, wherein a first intermediate boss interface is formed by an end of the one first intermediate boss and the second plate-like structure of the second shell correspondingly, and a second intermediate boss interface is formed by an end of the one second intermediate boss and the first plate-like structure of the first shell correspondingly, wherein the first intermediate boss interface and the second intermediate boss interface are not at the same height; or, the intermediate boss interface staggered structure may be formed by one first intermediate boss and two second intermediate bosses, wherein a first intermediate boss interface is formed by an end of one of the two second intermediate bosses and an end of one first intermediate boss correspondingly, and a second intermediate boss interface is formed by an end of the other one of the two second intermediate bosses and the first plate-like structure of the first shell correspondingly, wherein the first intermediate boss interface and the second intermediate boss interface are not at the same height; or, the intermediate boss interface staggered structure may be formed by two first intermediate bosses and one second intermediate boss, wherein a first intermediate boss interface is formed by an end of one of the two first intermediate bosses and an end of one second intermediate boss correspondingly, and a second intermediate boss interface is formed by an end of the other one of the two first intermediate bosses and the second plate-like structure of the second shell correspondingly, wherein the first intermediate boss interface and the second intermediate boss interface are not at the same height; or, the intermediate boss interface staggered structure may be formed by two first intermediate bosses and two second intermediate bosses, wherein two intermediate boss interfaces are formed, respectively, by ends of the two first intermediate bosses and ends of the two second intermediate bosses correspondingly, wherein the two intermediate boss interfaces are not at the same height; for the intermediate boss encapsulation structure, the intermediate boss encapsulation structure may be formed by two first intermediate bosses and two second intermediate bosses, wherein an end of an inner first intermediate boss of the two first bosses that is disposed on an inner side is corresponding to an end of an inner second intermediate boss of the two second intermediate bosses that is disposed on an inner side, and an end of an outer second intermediate boss of the two second intermediate bosses that is disposed on an outer side is corresponding to the first plate-like structure of the first shell, wherein an outer first intermediate boss of the two first intermediate bosses that is disposed on an outer side encapsulates the outer second intermediate boss from the outside; or, the intermediate boss encapsulation structure may be formed by two first intermediate bosses and one second intermediate boss, wherein an end of the one second intermediate boss is corresponding to the first plate-like structure of the first shell, and an end of the inner first intermediate boss of the two first intermediate bosses that is disposed on an inner side is corresponding to the second plate-like structure of the second shell, wherein the outer first intermediate boss of the two first intermediate bosses that is disposed on an outer side encapsulates one second intermediate boss from the outside; or, the intermediate boss encapsulation structure may be formed by two first intermediate bosses and two second intermediate bosses, wherein an end of an inner first intermediate boss of the two first bosses that is disposed on an inner side is corresponding to an end of an inner second intermediate boss of the two second intermediate bosses that is disposed on an inner side, and an end of an outer first intermediate boss of the two first intermediate bosses that is disposed on an outer side is corresponding to the second plate-like structure of the second shell, wherein an outer second intermediate boss of the two second intermediate bosses that is disposed on an outer side encapsulates the outer first intermediate boss from the outside; or, the boss encapsulation structure may be formed by one first intermediate boss and two second intermediate bosses, wherein an end of the inner second intermediate boss of the two second intermediate bosses that is disposed on an inner side is corresponding to the first plate-like structure of the first shell, and an end of one first intermediate boss is corresponding to the second plate-like structure of the second shell, wherein the outer second intermediate boss of the two second intermediate bosses that is disposed on an outer side encapsulates one first intermediate boss from the outside.

In an embodiment of the present disclosure, the at least a first intermediate isolation portion may be of the first isolation structure, and the first cavity is separated into a plurality of the first sub-cavities by the first isolation structure; and/or, the at least a first intermediate isolation portion may be of the second isolation structure, and the first cavity is separated into a plurality of the first sub-cavities by the second isolation structure; and/or, the at least a first intermediate isolation portion may include the first isolation structure and the second isolation structure, and the first cavity may be separated into a plurality of the first sub-cavities by the first isolation structure and the second isolation structure, wherein at least two adjacent first sub-cavities form a phase cavity in one phase, and phase cavities in different phases are isolated by the second isolation structure.

In an embodiment of the present disclosure, at least a third intermediate boss may be provided on a lower side of the lower wall of the first cavity, for separating the second cavity into at least two second sub-cavities.

In an embodiment of the present disclosure, the shell body may include a first shell and a separator plate; the first shell may include a lower wall and two side walls disposed on opposite sides of the lower wall and extending in the first direction, the two side walls extending inward in a second direction to form a convex structure, and the separator plate being installed by fitting to the convex structure to form the first structure and forming the first cavity with the first shell.

In an embodiment of the present disclosure, the first shell may further include an upper wall opposite to the lower wall, and the separator plate is installed by fitting to the convex structure to separate an internal space of the first shell to form the first cavity and a second cavity; and the first shell may be integrally formed.

In an embodiment of the present disclosure, the shell body may further include a second shell; the second shell comprises an upper wall and two side walls disposed on opposite sides of the upper wall and extending in the first direction, the first shell and the second shell being fitted and connected in a detachable manner; the two side walls of the first shell and the two side walls of the second shell are fitted and connected in an opposite way in the first direction to form an internal space; the separator plate separates the internal space to form the first cavity and a second cavity; and the first shell may be integrally formed, and the second shell may be integrally formed.

In an embodiment of the present disclosure, a concave part may be further formed on the separator plate; and/or, the first shell and the separator plate may be made of insulating material.

In an embodiment of the present disclosure, the convex structure may be a U-shaped groove structure, each U-shaped groove structure including two groove walls that are opposite to each other and a groove disposed between the two groove walls; the separator plate may be installed in the U-shaped groove structure by inserting its two ends in the U-shaped groove structure, without providing the shielding layer on the inserted parts of the two ends of the separator plate; the two side walls of the first shell may be provided with first side wall shielding layers disposed near the first cavity and second side wall shielding layers disposed far away from the first cavity; the lower wall of the first shell may be provided with an inner lower wall shielding layer disposed near the first cavity and an outer lower wall shielding layer disposed far away from the first cavity; a first groove wall of the two groove walls of each U-shaped groove structure that is positioned correspondingly on the inner side of the first cavity may be provided with a first groove wall shielding layer disposed near the first cavity; a second groove wall of the two groove walls of each U-shaped groove structure that is positioned correspondingly on the outer side of the first cavity may be provided with a second groove wall shielding layer disposed far away from the first cavity; the separator plate may be provided with a first separator plate shielding layer disposed near the first cavity and a second separator plate shielding layer disposed far away from the first cavity; the first groove wall shielding layer, the first groove wall of the U-shaped groove structure, the gap portion remained in the groove of the inserted U-shaped groove structure, the second groove wall of the U-shaped groove structure, and the second groove wall shielding layer may form, respectively, the first shielding layer, the first insulating layer, the first air gap layer, the second insulating layer, and the second shielding layer of the first structure correspondingly; the first groove wall shielding layer, the first separator plate wall shielding layer, the first side wall shielding layer, and the inner lower wall shielding layer may form the inner shielding layer correspondingly, two adjacent shielding layers of multiple shielding layers which form the inner shielding layer being connected directly, or connected through conductive tapes or metal plates; and the second groove wall shielding layer, the second separator plate shielding layer, the second side wall shielding layer, and the outer lower wall shielding layer may form the outer shielding layer correspondingly.

In an embodiment of the present disclosure, the first side wall shielding layer may be disposed on the inner surface of the two side walls of the first shell that corresponds to the first cavity; the second side wall shielding layer may be disposed on the outer surface of the two side walls of the first shell that corresponds to the first cavity; the inner lower wall shielding layer may be disposed on the inner surface of the lower wall of the first shell that corresponds to the first cavity; the outer lower wall shielding layer may be disposed on the outer surface of the lower wall of the first shell that corresponds to the first cavity; the first groove wall shielding layer may be disposed on the outer surface of the first groove wall of the U-shaped groove structure; the second groove wall shielding layer may be disposed on the outer surface of the second groove wall of the U-shaped groove structure; the first separator plate shielding layer may be disposed on the inner surface of the separator plate that corresponds to the inner side of the first cavity; and the second separator plate shielding layer may be disposed on the outer surface of the separator plate that corresponds to the outer side of the first cavity.

In an embodiment of the present disclosure, the convex structure may be an I-shaped plate, the separator plate being installed on the I-shaped plate by attaching its two ends to the I-shaped plate, and a gap being formed by fitting and installing the separator plate and the I-shaped plate; the two side walls of the first shell may be provided with a first side wall shielding layer disposed near the first cavity and a second side wall shielding layer disposed far away from the first cavity; the lower wall of the first shell may be provided with an inner lower wall shielding layer disposed near the first cavity and an outer lower wall shielding layer disposed far away from the first cavity; each I-shaped plate may be provided with a first I-shaped plate shielding layer disposed near the first cavity; the separator plate may be provided with a first separator plate shielding layer disposed near the first cavity and a second separator plate shielding layer disposed far away from the first cavity; the first I-shaped plate shielding layer, the I-shaped plate, the gap formed by fitting and installing the separator plate and the I-shaped plate, the installation portion for fitting and installing the separator plate and the I-shaped plate, and a partial shielding layer of the installation portion that corresponds to the second separator plate shielding layer may form, respectively, the first shielding layer, the first insulating layer, the first air gap layer, the second insulating layer and the second shielding layer of the first structure correspondingly; the first I-shaped plate shielding layer, the first separator plate shielding layer, the first side wall shielding layer, and the inner lower wall shielding layer may form at least a part of the inner shielding layer correspondingly, two adjacent shielding layers of multiple shielding layers which form the inner shielding layer being connected directly, or connected through conductive tapes or metal plates; and the second separator plate shielding layer, the second side wall shielding layer, and the outer lower wall shielding layer may form the outer shielding layer correspondingly.

In an embodiment of the present disclosure, the convex structure may be an I-shaped plate, the separator plate being installed below the I-shaped plate by attaching its two ends to the I-shaped plate, and a gap being formed by fitting and installing the separator plate and the I-shaped plate; the two side walls of the first shell may be provided with a first side wall shielding layer disposed near the first cavity and a second side wall shielding layer disposed far away from the first cavity; the lower wall of the first shell may be provided with an inner lower wall shielding layer disposed near the first cavity and an outer lower wall shielding layer disposed far away from the first cavity; each I-shaped plate may be provided with a second I-shaped plate shielding layer disposed far away the first cavity; the separator plate may be provided with a first separator plate shielding layer disposed near the first cavity and a second separator plate shielding layer disposed far away from the first cavity; a partial shielding layer of the first separator plate shielding layer that corresponds to the I-shaped plate, the installation portion for fitting and installing the separator plate and the I-shaped plate, the gap formed by fitting and installing the separator plate and the I-shaped plate, the I-shaped plate, and the second I-shaped plate shielding layer may form, respectively, the first shielding layer, first insulating layer, first air gap layer, the second insulating layer, and the second shielding layer of the first structure correspondingly; the first separator plate shielding layer, the first side wall shielding layers, and the inner lower wall shielding layer may form the inner shielding layer correspondingly, two adjacent shielding layers of multiple shielding layers which form the inner shielding layer being connected directly, or connected through conductive tapes or metal plates; and the second I-shaped plate shielding layer, the second separator plate shielding layer, the second side wall shielding layers, and the outer lower wall shielding layer may form the outer shielding layer OS correspondingly.

In order to achieve the above purpose, the present disclosure additionally provides an electronic device, including a shielded insulating shell which includes a shell body provided with a first cavity, with an inner shielding layer near the first cavity and an outer shielding layer far away from the first cavity being formed on the shell body; a first structure formed on the first cavity, and formed by assembling to include at least a first shielding layer, a first insulating layer, a first air gap layer, a second insulating layer, and a second shielding layer arranged sequentially from an inner side to an outer side of the first cavity; and an assembling gap formed on the first structure, which cooperates with the first air gap layer to form a creepage path on the first structure that extends from the inner shielding layer to the outer shielding layer; and a high voltage module, which is accommodated in the first cavity of the shielded insulating shell.

In another embodiment of the present disclosure, the electronic device may further include a low voltage module which is accommodated in a second cavity of the shielded insulating shell.

In another embodiment of the present disclosure, the electronic device may further include a transformer, wherein primary magnetic core and a secondary magnetic core of the transformer are disposed on two sides of a concave portion formed on at least a partial plate-like structure of a second plate-like structure of a second shell of the shielded insulation shell, or the primary magnetic core and the secondary magnetic core of the transformer are disposed on two sides of a concave portion formed on a separator plate of the shielded insulation shell.

In another embodiment of the present disclosure, the first shell of the shielded insulating shell may further include at least a first intermediate boss disposed between at least two first bosses; the second shell of the shielded insulating shell may further include at least a second intermediate boss disposed between the at least two second bosses; wherein a first intermediate isolation portion is formed by the at least a first intermediate boss and/or the at least a second intermediate boss, for separating the first cavity into at least two first sub-cavities, wherein at least a high voltage module is disposed in each of the first sub-cavities; at least a low voltage module may be disposed in the at least a second cavity.

In another embodiment of the present disclosure, the electronic device may further include a plurality of high voltage modules, wherein the plurality of high voltage modules are cascaded and electrically connected to a single-phase electric power.

In another embodiment of the present disclosure, two high voltage modules in a first group are electrically connected to phase A of the three-phase electric power, two high voltage modules in a second group are electrically connected to phase B of the three-phase electric power, and two high voltage modules in a third group may be electrically connected to phase C of the three-phase electric power.

In another embodiment of the present disclosure, the two high voltage modules in the first group, the two high voltage modules in the second group, and the two high voltage modules in the third group may be arranged in order from left to right in a lateral direction; or, the two high voltage modules in the first group, the two high voltage modules in the second group, and the two high voltage modules in the third group may be arranged in order from up to down in a longitudinal direction.

The advantages of the present disclosure are as follows. (1) The shielded insulating shell of the present disclosure may be constructed with an increased creepage distance by utilizing the first structure formed by assembly, such as through the air gap in the first structure the creepage distance may be sufficiently constructed through the air gap formed by the first shell and the second shell, so that the number of shell components is small and the structure is simple. There may be a plurality of air gaps along the horizontal direction to further increase the creepage distance Thereby reducing the probability of insulation failure; if the system voltage is 10kV, the creepage distance shall not be less than 106mm. (2) The air gap is disposed between the high voltage shielding layer HSL and the low voltage shielding layer LSL, which increases the spacing between the high and low voltage shielding layers, reduces the electric field stress in the air near the edge of the high voltage shielding layer, improves the partial discharge level of the insulating shell, and enhances the electrical performance yield of the shell. (3) the electrical clearance distance and creepage distance may be further increased by provision of an independent insulating layer.

Additional aspects and advantages of the present disclosure will be set forth in part in the following description, and will become apparent in part from the description, or may be learned through the practice of the present disclosure.

BRIEF DESCRIPTION OF THE DRAWINGS

The above and other features and advantages of the present disclosure will become more apparent by describing the exemplary embodiments thereof in detail with reference to the drawings.

FIG. 1 is a schematic diagram of the composition of the SST system according to the present disclosure;

FIG. 2A is a three-dimensional structural schematic diagram of a shielded insulating shell according to a first preferred embodiment of the present disclosure;

FIG. 2B is a three-dimensional structural schematic diagram of the first shell of the shielded insulating shell in FIG. 2A;

FIG. 2C is a three-dimensional structural schematic diagram of the second shell of the shielded insulating shell in FIG. 2A;

FIG. 3 is a structural schematic diagram of the electronic device including the shielded insulating shell as shown in FIG. 2A, wherein a high voltage module and a low voltage module are which is accommodated in the first cavity and the second cavity of the shielded insulating shell;

FIG. 4A is a simplified diagram of the side portion of the shielded insulating shell as shown in FIG. 3;

FIG. 4B shows the electric field distribution along the x-axis of the side portion in FIG. 4A;

FIG. 5 shows the boss interface flush structure of the shielded insulating shell according to the present disclosure;

FIGS. 6A to 6D respectively show several cases of the boss interface staggered structure of the shielded insulating shell according to the present disclosure;

FIGS. 7A to 7D respectively show several cases of the boss encapsulation structure of the shielded insulating shell according to the present disclosure;

FIG. 8 is a structural schematic diagram of the electronic device including a shielded insulating shell having a boss encapsulation structure according to the present disclosure.

FIG. 9 shows the variation of the electric fields E1 and E2 at two positions in FIG. 8 with the distance $d_{12}$ between the ends of the inner first boss and the inner second boss;

FIG. 10 is a structural schematic diagram of the electronic device including a shielded insulating shell according to a second preferred embodiment of the present disclosure, wherein the first side wall shielding layer is disposed inside the innermost boss;

FIG. 11A is a structural schematic diagram of the electronic device including a shielded insulating shell according to a third preferred embodiment of the present disclosure, wherein when the first side wall shielding layer is disposed inside the innermost boss, an independent insulating layer is provided between the innermost boss and a high voltage module which is accommodated in the first cavity;

FIG. 11B is a structural schematic diagram of the electronic device including a shielded insulating shell according to a fourth preferred embodiment of the present disclosure, wherein an independent insulating layer is provided in the first side wall air gap layer;

FIG. 12 is a structural schematic diagram of the electronic device including a shielded insulating shell according to a fifth preferred embodiment of the present disclosure, wherein at least part of the second plate-like structure of the second shell forms a concave portion on the plate-like structure for disposing a primary magnetic core and a secondary magnetic core of a transformer;

FIG. 13A is a structural schematic diagram of the electronic device including a shielded insulating shell according to a sixth preferred embodiment of the present disclosure, wherein only the first cavity is formed to accommodate the high voltage module;

FIG. 13B is a structural schematic diagram of the electronic device including a shielded insulating shell according to a seventh preferred embodiment of the present disclosure, wherein the second cavity is separated into two second sub-cavities, each of which is used to accommodate one low voltage module;

FIG. 14 is a structural schematic diagram of the electronic device including a shielded insulating shell according to an eighth preferred embodiment of the present disclosure, wherein a plurality of independent insulating shells are placed side by side;

FIG. 15A is a structural schematic diagram of the electronic device including a shielded insulating shell according to a ninth preferred embodiment of the present disclosure, wherein the first cavity is separated into a plurality of first sub-cavities by a first isolation structure, and two intermediate bosses forming the first isolation structure are not contacted with each other;

FIG. 15B is a structural schematic diagram of the electronic device including a shielded insulating shell according to a tenth preferred embodiment of the present disclosure, wherein the first cavity is separated into a plurality of first sub-cavities by a first isolation structure, and two intermediate bosses forming the first isolation structure are contacted with each other;

FIG. 15C is a structural schematic diagram of the electronic device including a shielded insulating shell according to an eleventh preferred embodiment of the present disclosure, wherein the first cavity is separated into a plurality of first sub-cavities by a first isolation structure and a second isolation structure; two adjacent first sub-cavities form a phase cavity in one phase, and the phase cavities in different phases are isolated by a second isolation structure.

FIG. 16A shows a structural schematic diagram of a plurality of high voltage modules in the first cavity arranged in order from left to right in the lateral direction;

FIG. 16B shows a structural schematic diagram of a plurality of high voltage modules in the first cavity arranged in order from up to down in the longitudinal direction;

FIG. 17 shows the circuit structure inside the one-driven-two power unit applicable to the shielded insulating shell as shown in FIG. 13B;

FIG. 18A is a structural schematic diagram of an electronic device including a shielded insulating shell according to a twelfth preferred embodiment of the present disclosure, wherein the first and second cavities of the shielded insulating shell may accommodate a high voltage module and a low voltage module respectively;

FIG. 18B is a three-dimensional structural schematic diagram of the first shell of the shielded insulating shell in FIG. 18A;

FIG. 19A is a structural schematic diagram of an electronic device including a shielded insulating shell according to a thirteenth preferred embodiment of the present disclosure, wherein the first and second cavities of the shielded insulating shell may accommodate a high voltage module and a low voltage module respectively;

FIG. 19B is a three-dimensional structural schematic diagram of the first and second shells in a separated state of the shielded insulating shell in FIG. 19A;

FIG. 20A is a structural schematic diagram of an electronic device including a shielded insulating shell according to a fourteenth preferred embodiment of the present disclosure, wherein the first and second cavities of the shielded insulating shell may accommodate a high voltage module and a low voltage module respectively;

FIG. 20B is a three-dimensional structural schematic diagram of the first shell of the shielded insulating shell in FIG. 20A; and

FIG. 21 is a structural schematic diagram of an electronic device including a shielded insulating shell according to a fifteenth preferred embodiment of the present disclosure.

## DETAILED EMBODIMENTS OF THE DISCLOSURE

Exemplary embodiments will now be described more fully with reference to the accompanying drawing. However, the exemplary embodiments may be implemented in many forms and should not be construed as limited to the embodiments set forth herein. On the contrary, these exemplary embodiments are provided so that this disclosure will be comprehensive and complete, and will the conception of exemplary embodiments will be fully conveyed to those skilled in the art. The same reference numerals in the drawings denote the same or similar structures, and thus detailed descriptions thereof will be omitted.

When introducing the elements/components/etc. described and/or illustrated herein, the terms "one", "a", "this", "the" and "at least a" are used to indicate the existence of one or more elements/components/etc. The terms "contain", "include" and "have" are used to mean open inclusion and mean that there may be other elements/components/etc. in addition to the listed elements/components/etc. The terms "connection", "splicing" and "abutment" are used to indicate the direct connection or indirect connection between two elements/components (that is, there are other elements/components between two elements/components, for example, including but not limited to air). In addition, the terms "first", "second" and the like in the claims are only used as marks, and are not numerical restrictions on their objects.

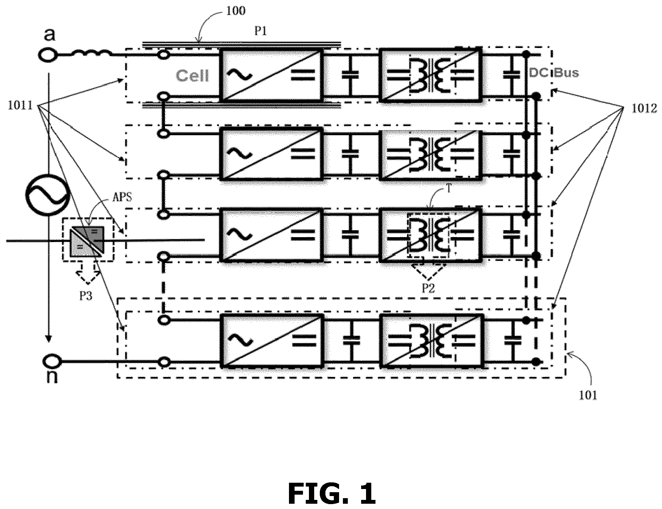

FIG. 1 shows the composition of the SST system applied to the shielded insulating shell of the present disclosure. The input side of SST system may be used to receive medium voltage AC input voltage (such as input voltage of 10kV, 13.8kV or 20kV), and the output side may be used to output low voltage DC voltage (such as output voltage of 1kV). The SST system may be composed of a plurality of power modules 101 in cascade. For example, only four power modules 101 are schematically shown in cascade between the input node a and the input node n in FIG. 1. However, it may be understood that the number of power modules 101 is not limited thereto. Each power module 101 may include a transformer T, a high voltage module circuit 1011 disposed on the high voltage side of the transformer T, and a low voltage module circuit 1012 disposed on the low voltage side of the transformer T. The high voltage module circuit 1011 may include two-stage conversion circuits: an AC/DC conversion circuit at the preceding stage and a DC/DC conversion circuit at the backward stage.

In the present disclosure, for a plurality of positions requiring medium voltage insulation in the whole SST system, such as phase-to-phase insulation and shell-to-shell insulation at position P1, insulation between high and low voltage module circuits and insulation between the primary side and the secondary side of the high frequency transformer at position P2, insulation between the medium voltage (MV) side of the auxiliary power supply of the auxiliary power source (APS) and the safety extra low voltage (SELV) side of the electric supply at position P3, the shielded insulating shell 100 of the present disclosure may realize insulation at the positions P1, P2 and P3.

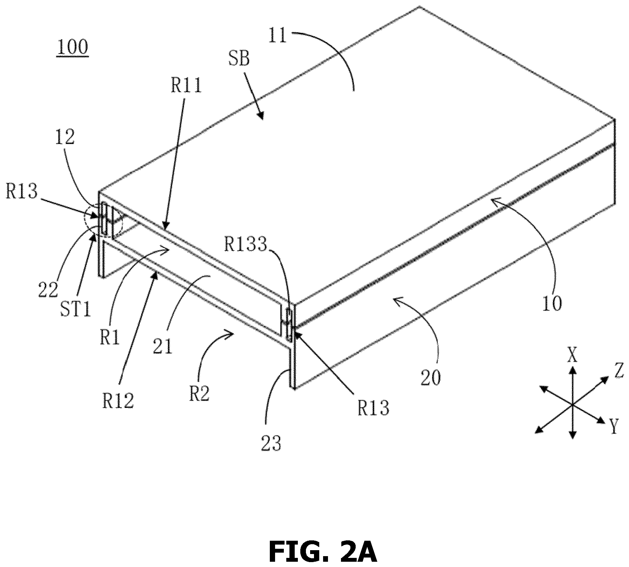

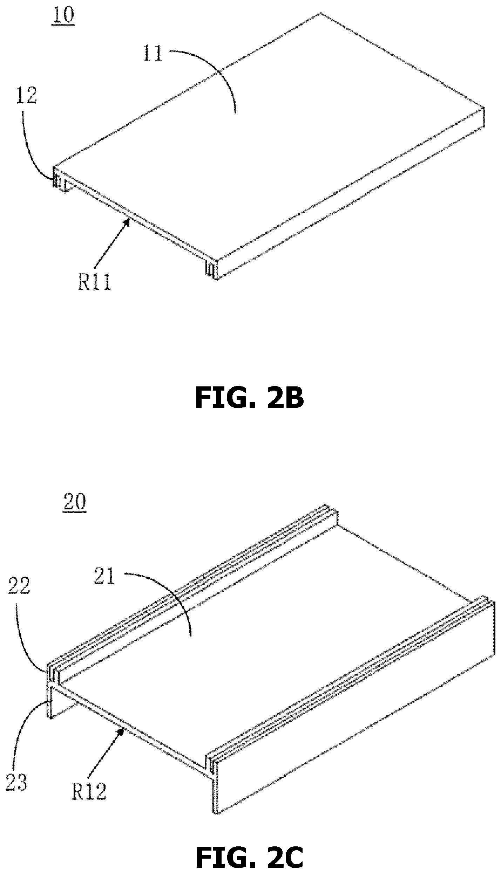

The structure of the shielded insulating shell of the present disclosure will be described in detail below with reference to FIGS. 2A to 20B.

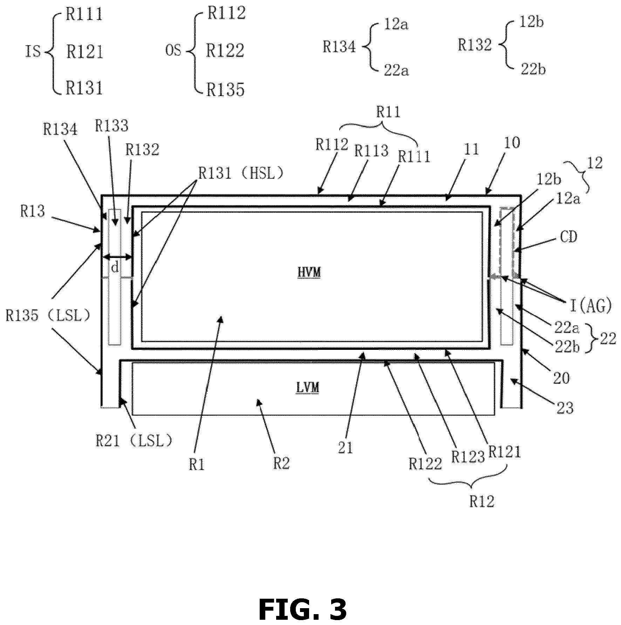

As shown in FIGS. 2A to 2C and FIG. 3, the shielded insulating shell 100 according to the present disclosure includes a shell body SB and a first structure ST1. The shell body SB is provided with a first cavity R1. An inner shielding layer IS near the first cavity R1 and an outer shielding layer OS far away from the first cavity R1 are formed on the shell body SB. The first structure ST1 is formed on the first cavity R1. The first structure ST1 is formed by assembling, and includes at least a first shielding layer, a first insulating layer, a first air gap layer, a second insulating layer, and a second shielding layer arranged sequentially from an inner side to an outer side of the first cavity R1. The inner shielding layer IS and outer shielding layer OS of the first cavity R1 are both formed by assembling at least one first portion and one second portion. The first portion is a part of the first shell, and the second portion is a part of the second shell or a separator plate. The first structure ST1 is also provided with an assembling gap, which is combined with the first air gap layer to form a creepage path on the first structure ST1 that extends from the inner shielding layer IS to the outer shielding layer OS, to form an increased creepage distance in the assembled first structure ST1.

In this embodiment, for example, the shell body SB may preferably include a first shell 10 and a second shell 20. The first shell 10 includes a first plate-like structure 11 and at least two first bosses 12 respectively disposed on two opposite sides of the first plate-like structure 11 and extending along a first direction (such as the vertical direction X in FIG. 2A). The second shell 20 includes a second plate-like structure 21 and at least two second bosses 22 respectively disposed on two opposite sides of the second plate-like structure 21 and extending along the first direction (such as the vertical direction X in FIG. 2A). The first shell 10 and the second shell 20 are fitted and connected by the at least two first bosses 12 and the at least two second bosses 22 to form a first cavity R1. The upper wall R11 of the first cavity R1 is formed by the first plate-like structure 11 and includes two upper wall shielding layers (such as an inner upper wall shielding layer R111 on the inner side and an outer upper wall shielding layer R112 on the outer side) and an upper wall insulating layer R113 between the two upper wall shielding layers. The lower wall R12 of the first cavity R1 is formed by the second plate-like structure 21 and includes two lower wall shielding layers (such as an inner lower wall shielding layer R121 on the inner side and an outer lower wall shielding layer R122 on the outer side) and a lower wall insulating layer R123 disposed between the two lower wall shielding layers. The two side walls R13 of the first cavity R1 are disposed between the upper wall R11 and the lower wall R12 and are respectively formed by the first boss 12 and the second boss 21 which are correspondingly fitted and connected. Each of the side walls R13, for example, may include a first side wall shielding layer R131, a first side wall insulating layer R132, a first side wall air gap layer R133, a second side wall insulating layer R134, and a second side wall shielding layer R135, which form, respectively, the first shielding layer, the first insulating layer, the first air gap layer, the second insulating layer, and the second shielding layer in the first structure ST1 correspondingly.

In this embodiment, the inner upper wall shielding layer R111, the inner lower wall shielding layer R121, and the first side wall shielding layer R131 form the inner shielding layer IS correspondingly. The first side wall shielding layer R131 is formed by assembling at least a first partial inner shielding layer and a second partial inner shielding layer. The first partial inner shielding layer is a part of the first shell 10, and the inner shielding layer of the second portion is a part of the second shell 20. The outer upper wall shielding layer R112, the outer lower wall shielding layer R122, and the second side wall shielding layer R135 form the outer shielding layer OS correspondingly. The second side wall shielding layer R135 is formed by assembling at least a first partial outer wall shielding layer and a second partial outer wall shielding layer. The first partial outer wall shielding layer is a part of the first shell 10, and the second partial outer wall shielding layer is a part of the second shell 20.

In the embodiment as shown in FIG. 3, the first boss 12 and the second boss 21 may be fitted and connected directly (i.e., contacted with each other). However, it may be understood that, in some other embodiments, the first boss 12 and the second boss 21 may be fitted and connected indirectly (for example, including but not limited to the air gap therebetween), which is not intended to limit the present disclosure. There is an assembling gap at the connection point where the first boss 12 and the second boss 22 are fitted and connected correspondingly (for example, corresponding to the boss interface I). The assembling gap and the first air gap layer may be combined to form a creepage path on the first structure ST1 that extends from the inner shielding layer IS to the outer shielding layer OS. For example, the space through which the creepage distance CD extends as shown by the dashed line in FIG. 3 is the creepage path.

In some embodiments of the present disclosure, the shielded insulating shell 100, for example, may be a detachable structure, and the first shell 10 and the second shell 20, for example, may be connected and assembled through a detachable connector (including but not limited to bolts, nuts, etc.), so that assembly is more convenient and fast.

In some embodiments of the present disclosure, at least two third bosses 23 may be further provided on a lower side of the lower wall R12 of the first cavity R1. The at least two third bosses 23 and the lower wall R12 of the first cavity R1 form a second cavity R2. Preferably, the first cavity R1 may be, for example, a surrounding structure surrounded by insulation on the upper, lower, left and right sides, and the second cavity R2 may be, for example, a half opening structure with an opening on the lower side (i.e., the upper, left and right sides are surrounded by insulation). In the present disclosure, the first cavity R1, for example, may be used to accommodate a high voltage module (HV module) HVM, and the second cavity R2 may be used to accommodate a low voltage module (LV module) LVM, but the present disclosure is not limited thereto. In other embodiments, the first cavity R1 and the second cavity R2 may also be used to accommodate other power modules, for example, the first cavity R1 is used to accommodate the primary side of the high frequency transformer, and the second cavity R2 is used to accommodate the secondary side of the high frequency transformer; or, the first cavity R1 and the second cavity R2 are respectively used to accommodate power modules with different phases, which is not intended to limit the present disclosure.

In some embodiments of the present disclosure, the high voltage module includes a primary conversion circuit, and may further include other power modules, such as a primary side magnetic core of a transformer and a primary side winding of the transformer. The low voltage module includes a secondary conversion circuit, and may further include other power modules, such as a secondary side magnetic core of the transformer and a secondary side winding of the transformer. The transformer may include a main transformer and an auxiliary power transformer.

In some embodiments of the present disclosure, the top surface of the first side wall air gap layer R133 may be a part of the first shell 10, for example, may be formed by extending outward from two sides of the first plate-like structure 11. The bottom surface of the first side wall air gap layer R133 may be a part of the second shell 20, for example, may be formed by extending outward from two sides of the second plate-like structure 21.

In some embodiments of the present disclosure, the upper wall insulating layer R113, the lower wall insulating layer R123, the first side wall insulating layer r132, the second side wall insulating layer R134, and the third boss 23 may be solid insulation SI, and the insulating material thereof may be, for example, epoxy resin, polyurethane, or silicone rubber. the medium in the first side wall air gap layer R133 may be, for example, air, sulfur hexafluoride gas or insulating oil. In the present disclosure, the first side wall insulating layer R132, the second side wall insulating layer R134 and the first side wall air gap layer R133 therebetween form a composite insulating structure with a total insulating thickness d.

In the present disclosure, each side wall R13 of the first cavity R1 includes at least one of the first bosses 12 and at least one of the second bosses 22. For the convenience of description, one of the first boss 12 and the second boss 22 that is disposed at the innermost side is defined as the innermost boss, and one of the first boss 12 and the second boss 22 that is disposed at the outermost side is defined as the outermost boss.

In a preferred embodiment of the present disclosure, the shielding layer may include an inner shielding layer IS and an outer shielding layer OS, and the positions thereof are illustrated by taking FIG. 3 as an example. The inner shielding layer IS is disposed on the innermost surface of the insulating structure formed by the first shell 10 and the second shell 20, and its position includes all the insulating surfaces immediately adjacent to the high voltage module HVM, for example, the upper wall shielding layer R111 disposed correspondingly on the inner surface of the upper wall insulating layer R113, the lower wall shielding layer R121 disposed correspondingly on the inner surface of the lower insulating layer R123, and the first side wall shielding layer R131 disposed correspondingly on the inner surface of the innermost boss in FIG. 3. These inner shielding layers may be, for example, high voltage shielding layers HSL. The outer shielding layer OS is disposed on the outermost surface of the insulating structure formed by the first shell 10 and the second shell 20, and its position includes all the insulating surfaces immediately adjacent to the low voltage module LVM, for example, the upper wall shielding layer R112 disposed correspondingly on the outer surface of the upper wall insulating layer R113, the lower wall shielding layer R122 disposed correspondingly on the outer surface of the lower insulating layer R123, the second side wall shielding layer R135 disposed correspondingly on the outer surface of the outermost boss, and the second cavity shielding layer R21 disposed on the insulating surface immediately adjacent to the low voltage module LVM in FIG. 3. These outer shielding layers may be, for example, low voltage shielding layers LSL.

In the present disclosure, the materials of these shielding layers may be metal materials or semiconductive materials, and the thickness of the shielding layer may not be limited, but its surface resistance must not be greater than 500 kohm. Preferably, the shielding layers of the two upper wall shielding layers R111 and R112, the two lower wall shielding layers R121 and R122, the first side wall shielding layer R131, and the second side wall shielding layer R135 may be, for example, galvanized coating layers, sheet metal layers or semiconductive layers. More preferably, the shielding layers of the two upper wall shielding layers R111 and R112, the two lower wall shielding layers R121 and R122, the first side wall shielding layer R131, and the second side wall shielding layer R135 may be perforated plate-like structures (for example, an embedded mesh structure) or non-perforated plate-like structures (for example, a complete plate-like structure).

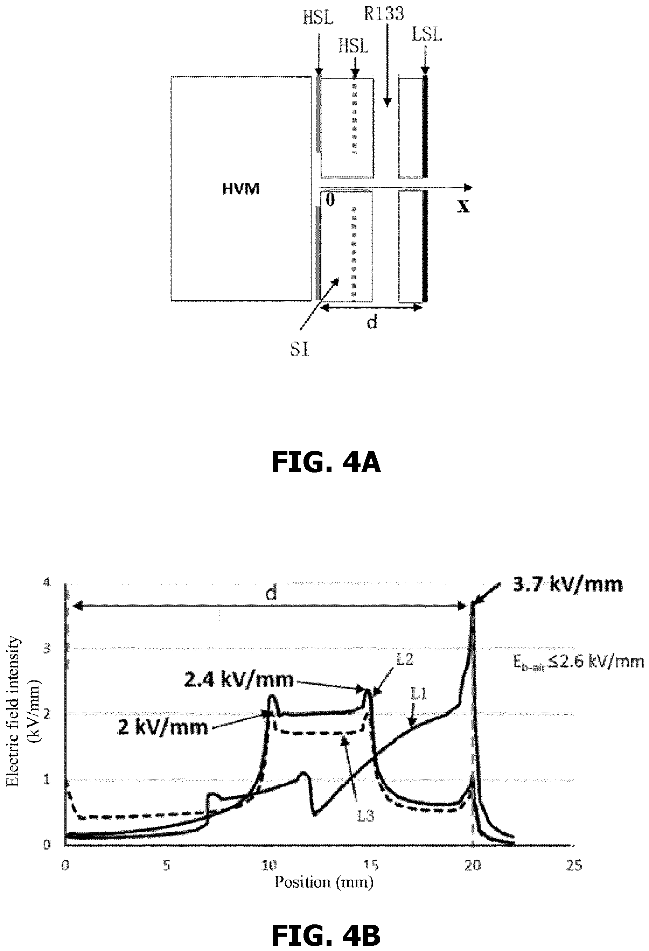

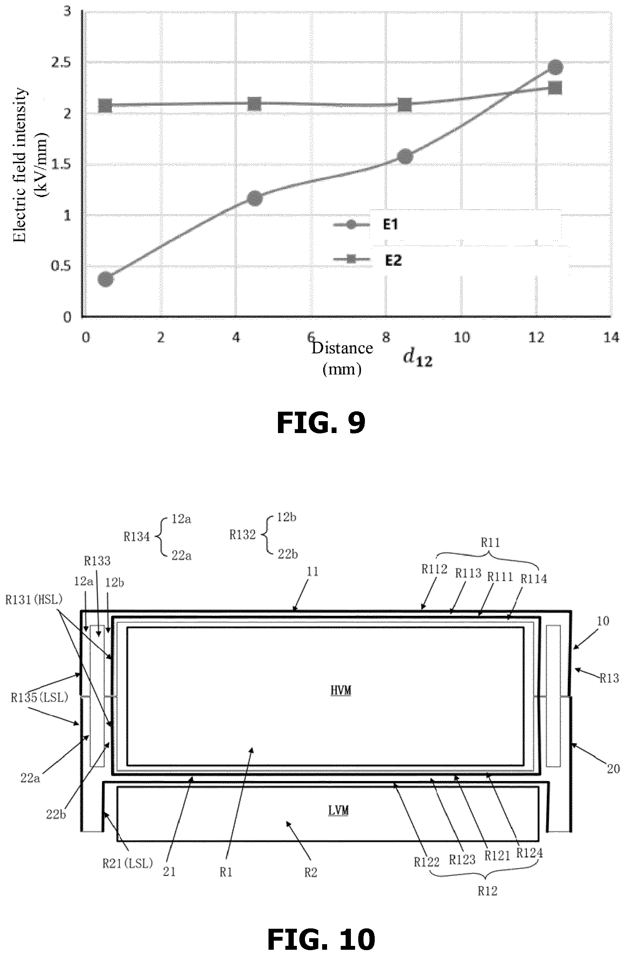

FIG. 4A is a simplified diagram of the side portion of the shielded insulating shell as shown in FIG. 3; FIG. 4B shows the electric field distribution along the x-axis of the side portion in FIG. 4A. As shown in FIGS. 4A to 4B, in the present disclosure, the first side wall air gap layer R133 is disposed between the high voltage shielding layer HSL (corresponding to the first side wall shielding layer R131 in FIG. 3) and the low voltage shielding layer LSL (corresponding to the second side wall shield layer R135 in FIG. 3), whereas in the prior art, the air gap is disposed outside the high voltage shielding layer and the low voltage shielding layer. If the total insulation thickness d of the shell side wall is consistent, with respect to the prior art, the distance between the high voltage shielding layer HSL and the low voltage shielding layer LSL in the present disclosure is relatively far (the high voltage shielding layer HSL may be disposed on the surface or inside of the solid insulation SI (see FIG. 10 for more detailed structure). By keeping the calculation parameters consistent, for example, assuming that the high voltage shielding voltage is 17kV, the total insulation thickness d is 20mm, and the dielectric constant of the solid insulation $\varepsilon$ is 4.4, the electric field distribution along the x-axis of the insulating shell of the prior art is as shown by the solid line L1 in FIG. 4B, while the electric field distribution along the x-axis of the shielded insulating shell of the present disclosure is as shown by the solid line L2 (corresponding to the high voltage shielding HSL disposed inside the solid insulation SI) and the dotted line L3 (corresponding to the high voltage shielding HSL disposed on the surface of the solid insulation SI) in FIG. 4B. As may be seen from FIG. 4B, compared with the prior art (as shown by the solid line L1 in FIG. 4B), the structure in which the high voltage shielding HSL of the present disclosure is disposed on the surface of the solid insulation (that is, the high voltage shielding layer HSL as shown in FIG. 3 is disposed on the inner surface of the solid insulation SI) may make the electric field distribution more uniform, and the maximum electric field may be reduced from 3.7kV/mm in the prior art to 2kV/mm in the present disclosure. If the high voltage shielding layer HSL in the present disclosure is disposed inside the solid insulation (i.e., the high voltage shielding layer HSL as shown in FIG. 10 is disposed inside the solid insulation SI), as shown by the solid line L2 in FIG. 4B, since the distance between the high voltage shielding layer HSL and the low voltage shielding layer LSL decreases, the maximum electric field increases (for example, from 2kV/mm to 2.4kV/mm). As may be seen from FIG. 4B, the present disclosure greatly reduces the electric field stress in the air at the edge of the shielding layer, and may make the maximum electric field lower than the breakdown field strength of the air by 2.6kV/mm, thereby improving the partial discharge level of the insulating shell and improving the electrical performance yield of the shell.

According to the present disclosure, an increased creepage distance may be constructed by using the first structure ST1 which is formed by assembling. For example, the creepage distance (for example, the creepage distance CD as shown by the dotted line in FIG. 3, wherein, the space through which the creepage distance CD extends is the creepage path) may be sufficiently constructed with the air gap (for example, the assembling gap between the first side wall air gap layer R133 and the first and second bosses 12 and 22) formed by fitting and connecting the first shell 10 and the second shell 20, so that the number of shell components is small and the structure is simple. Moreover, the present disclosure may increase the spacing between two shielding layers, thereby reducing the electric field stress in the air near the edge of the high voltage shielding layer, and improving the partial discharge level of the insulating shell, and enhancing the electrical performance yield of the shell.

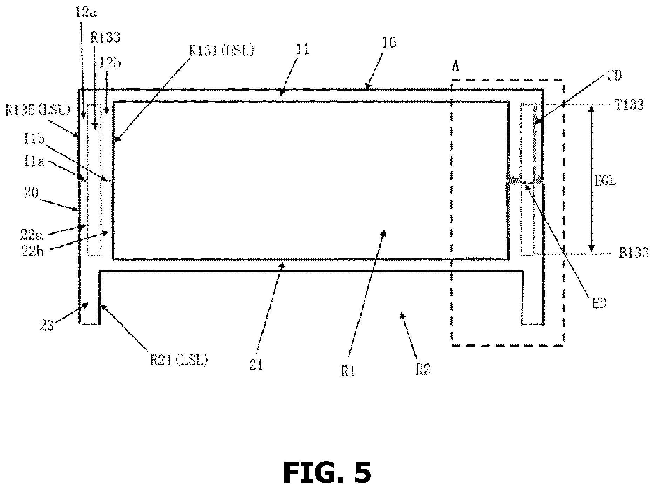

In some embodiments of the present disclosure, as shown in FIG. 3, a boss interface I is formed at a position where the first boss 12 and the second boss 22 are fitted and connected. For example, an assembling gap AG may be formed correspondingly at the boss interface I. Preferably, referring to FIG. 5, a boss interface flush structure is formed at a position where the first boss 12 and the second boss 22 are fitted and connected. Each side of the two sides of the first shell 10 provided with the first boss includes two first bosses 12a and 12b, and each side of the two sides of the second shell 20 provided with the first boss includes two second bosses 22a and 22b. The two first bosses 12a and 12b and the two second bosses 22a and 22b on each side are correspondingly jointed to form two boss interfaces I1a and I1b. The two boss interfaces I1a and I1b may be disposed at the same height, and is disposed between the top surface T133 and the bottom surface B133 of the first side wall air gap layer R133. In the embodiment as shown in FIG. 5, an electrical clearance length EGL is also defined between the top surface T133 and the bottom surface B133 of the first side wall air gap layer R133. An electrical clearance distance ED is also defined between the first side wall shielding layer R131 and the second side wall shielding layer R135. In the embodiment shown in FIG. 5, for example, assembling gaps may be formed correspondingly at the interfaces I1a and I1b of the two protrusions, which may be combined with the first air gap layer to form a creepage path on the first structure ST1 (see FIG. 2A) that extends from the inner shielding layer (such as the high voltage shielding layer HSL) to the outer shielding layer (such as the low voltage shielding layer LSL). For example, the space through which the creepage distance CD extends as shown by the dashed line in FIG. 5 is the creepage path.

Preferably, the two boss interfaces I1a and I1b are centrally disposed on a middle plane of the planes T133 and B133. When the two boss interfaces I1a and I1b are centered up and down, the creepage distance CD is the largest (about twice the length of the corresponding air gap). At the time, the maximum height of the first boss and the second boss is the smallest, which is half of the thickness of the high voltage module. The smaller the height of the boss, the higher the mechanical strength of the boss and the higher the reliability of the shell.

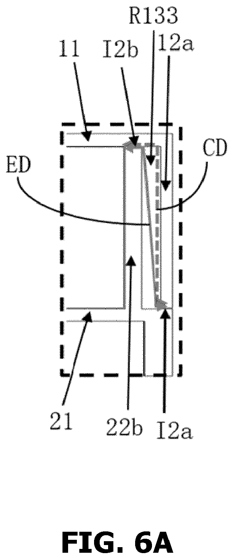

In some embodiments of the present disclosure, for example, a boss interface staggered structure is formed at the position where the first boss and the second boss are fitted and connected, as shown in FIGS. 6A to 6D. Taking the part A as shown in the imaginary frame in FIG. 5 as an example, FIGS. 6A to 6D respectively show several cases of the boss interface staggered structure, and the relevant shielding layers are omitted in FIGS. 6A to 6D for the sake of clarity. Compared with the boss interface flush structure as shown in FIG. 5, the boss interface staggered structure as shown in FIGS. 6A to 6D may increase the electrical clearance distance ED between high and low voltages.

As in the first case of the boss interface staggered structure shown in FIG. 6a, each side of the two sides of the first shell provided with the first boss includes a first boss 12a, and each side of the two sides of the second shell provided with the second boss includes a second boss 22b. An end of the first boss 12a is jointed with the second plate-like structure 21 of the second shell to form a first boss interface I2A, and an end of the second boss 22b is jointed with the first plate-like structure 11 of the first shell to form a second boss interface I2b; the first boss interface I2A and the second boss interface I2b are not at the same height. The creepage distance CD and the electrical clearance distance ED constructed by the first shell and the second shell are as shown in FIG. 6A. The boss interface staggered structure in the first case may obtain the maximum electrical clearance, which is conducive to reducing the volume of the insulating shell and increasing the power density of the system. In the embodiment shown in FIG. 6A, for example, assembling gaps may be formed correspondingly at the first boss interface I2a and the second boss interface I2b, which may be combined with the first air gap layer to form a creepage path on the first structure ST1 that extends from the inner shielding layer to the outer shielding layer (referring to FIG. 2A). For example, the space through which the creepage distance CD extends as shown by the dashed line in FIG. 6A is the creepage path.

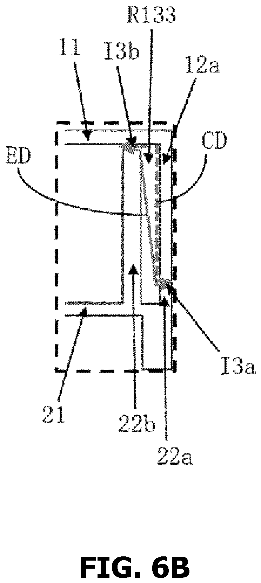

In the second case of the boss interface staggered structure as shown in FIG. 6B, each side of the two sides of the first shell provided with the first boss includes one first boss 12a, and each side of the two sides of the second shell provided with the second boss includes two second bosses 22a and 22b. An end of the second boss 22a (i.e., one of the two second bosses) is jointed with an end of the first boss 12a to form the first boss interface I3A, and an end of the second boss 22b (i.e., the other of the two second bosses) is jointed with the first plate-like structure 11 of the first shell to form a second boss interface I3b; the first boss interface I3a and the second boss interface I3b are not at the same height. The creepage distance CD and the electrical clearance distance ED constructed by the first shell and the second shell are as shown in FIG. 6B. In the embodiment shown in FIG. 6B, for example, assembling gaps may be formed correspondingly at the first boss interface I3a and the second boss interface I3b, which may be combined with the first air gap layer to form a creepage path on the first structure ST1 that extends from the inner shielding layer to the outer shielding layer (referring to FIG. 2A). For example, the space through which the creepage distance CD extends as shown by the dashed line in FIG. 6B is the creepage path.

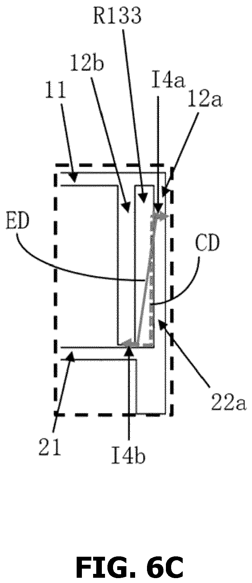

In the third case of the boss interface staggered structure as shown in FIG. 6C, each side of the two sides of the first shell provided with the first boss includes two first bosses 12a and 12b, and each side of the two sides of the second shell provided with the second boss includes one second boss 22a. An end of the first boss 12a (i.e., one of the two first bosses) is jointed with an end of the second boss 22a to form the first boss interface I4a, and an end of the first boss 12b (i.e., the other of the two first bosses) is jointed with the second plate-like structure 21 of the second shell to form a second boss interface I4b; the first boss interface I4a and the second boss interface I4b are not at the same height. The creepage distance CD and the electrical clearance distance ED constructed by the first shell and the second shell are as shown in FIG. 6C. In the embodiment shown in FIG. 6C, for example, assembling gaps may be formed correspondingly at the first boss interface I4a and the second boss interface I4b, which may be combined with the first air gap layer to form a creepage path on the first structure ST1 that extends from the inner shielding layer to the outer shielding layer (referring to FIG. 2A). For example, the space through which the creepage distance CD extends as shown by the dashed line in FIG. 6C is the creepage path.

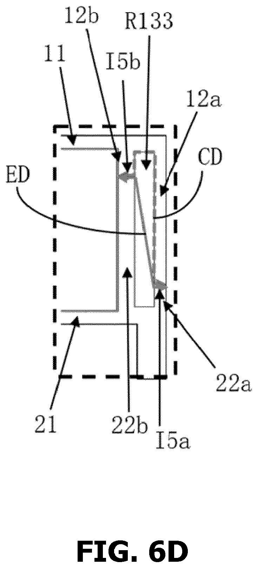

In the fourth case of the boss interface staggered structure as shown in FIG. 6D, each side of the two sides of the first shell provided with the first boss includes two first bosses 12a and 12b, and each side of the two sides of the second shell provided with the second boss includes two second bosses 22a and 22b. The ends of the two first bosses 12a and 12b are jointed with the ends of the two second bosses 22a and 22b to form two boss interfaces I5a and I5b respectively; the two boss interfaces I5a and I5b are not at the same height. The creepage distance CD and the electrical clearance distance ED constructed by the first shell and the second shell are as shown in FIG. 6D. In the embodiment shown in FIG. 6D, for example, assembling gaps may be formed correspondingly at the interfaces I5a and I5b of the two protrusions, which may be combined with the first air gap layer to form a creepage path on the first structure ST1 that extends from the inner shielding layer to the outer shielding layer (see FIG. 2A). For example, the space through which the creepage distance CD extends as shown by the dashed line in FIG. 6D is the creepage path.

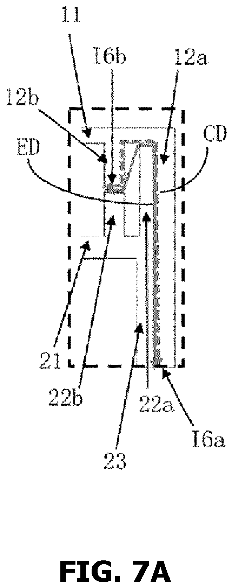

In some embodiments of the present disclosure, the first boss and the second boss are fitted and connected, for example, to form a boss encapsulation structure, as shown in FIGS. 7A to 7D. Taking the part A as shown in the imaginary frame in FIG. 5 as an example, FIGS. 7A to 7D respectively show several cases of the boss encapsulation structure, and the relevant shielding layers are omitted in FIGS. 7A to 7D for the sake of clarity. The boss encapsulation structure as shown in FIGS. 7A to 7D may increase the creepage distance CD and the electrical clearance distance ED, which is conducive to reducing the volume of the insulating shell and increasing the power density of the system. Meanwhile, the boss encapsulation structure may further define the relative positions of the first shell and the second shell.

In the first case of the boss encapsulation structure as shown in FIG. 7A, each side of the two sides of the first shell provided with the first boss includes two first bosses 12a and 12b, and each side of the two sides of the second shell provided with the second boss includes two second bosses 22a and 22b. An end of the inner first boss 12b of the two first bosses that is disposed on an inner side is jointed with an end of the inner second boss 22b in the two second bosses that is disposed on an inner side (for example, to form a boss interface I6b), and an end of the outer second boss 22a in the two second bosses that is disposed on an outer side is jointed with the first plate-like structure 11 of the first shell; the outer first boss 12a of the two first bosses that is disposed on an outer side encapsulates from the outside the outer second boss 22a. In some embodiments, the outer first boss 12a may completely coat the outer second boss 22a, even further coat the third boss 23, or partially coat the outer second boss 22a. In the first case, the outer first boss 12a completely coats the outer surfaces of the outer second boss 22a and the third boss 23, that is, an end of the outer first boss 12a is substantially flush with an end of the third boss 23 (for example, to form a boss interface I6a). At this point, the creepage distance CD and the electrical clearance distance ED constructed by the first shell and the second shell are as shown in FIG. 7A. Compared with the embodiments as shown in FIG. 5 and FIGS. 6A to 6D, the creepage distance CD and the electrical clearance distance ED constructed by the boss encapsulation structure in the first case are significantly increased. In the embodiment shown in FIG. 7A, for example, assembling gaps may be formed correspondingly at least at the boss interface I6b, at a joining portion of the end of the outer second boss 22a with the first plate-shaped structure 11 of the first shell, and at an encapsulating portion of the outer first boss 12a and the outer second boss 22a, which may be combined with the first air gap layer to form a creepage path on the first structure ST1 that extends from the inner shielding layer to the outer shielding layer (see FIG. 2A for reference). For example, the space through which the creepage distance CD extends as shown by the dashed line in FIG. 7A is the creepage path.

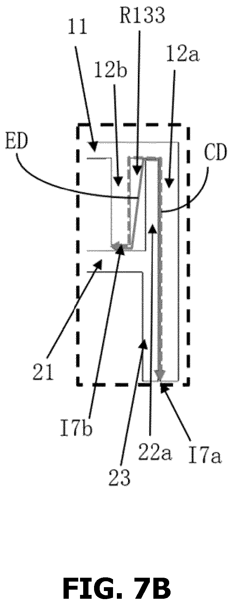

In the second case of the boss encapsulation structure as shown in FIG. 7B, each side of the two sides of the first shell provided with the first boss includes two first bosses 12a and 12b, and each side of the two sides of the second shell provided with the second boss includes one second boss 22a. An end of the second boss 22a is jointed with the first plate-like structure 11 of the first shell, and an end of the inner first boss 12b of the two first bosses that is disposed on an inner side is jointed with the second plate-like structure 21 of the second shell (for example, to form a boss interface I7b); the outer first boss 12a of the two first bosses that is disposed on an outer side encapsulates from the outside the outer second boss 22a. In some embodiments, the outer first boss 12a may completely coat the second boss 22a, even further coat the third boss 23, or partially coat the second boss 22a. In the second case, the outer first boss 12a completely coats the outer surfaces of the second boss 22a and the third boss 23, that is, an end of the outer first boss 12a is substantially flush with an end of the third boss 23 (for example, to form a boss interface I7a). At this point, the creepage distance CD and the electrical clearance distance ED constructed by the first shell and the second shell are as shown in FIG. 7B. Compared with the embodiments as shown in FIG. 5 and FIGS. 6A to 6D, the creepage distance CD and the electrical clearance distance ED constructed by the boss encapsulation structure in the second case are also significantly increased. In the embodiment shown in FIG. 7B, for example, assembling gaps may be formed correspondingly at least at the interface I7b of the boss, at a joining portion of the end of the second boss 22a with the first plate-shaped structure 11 of the first shell, and at an encapsulating portion of the outer first boss 12a and the second boss 22a, which may be combined with the first air gap layer to form a creepage path on the first structure ST1 that extends from the inner shielding layer to the outer shielding layer (see FIG. 2A). For example, the space through which the creepage distance CD extends as shown by the dashed line in FIG. 7B is the creepage path.

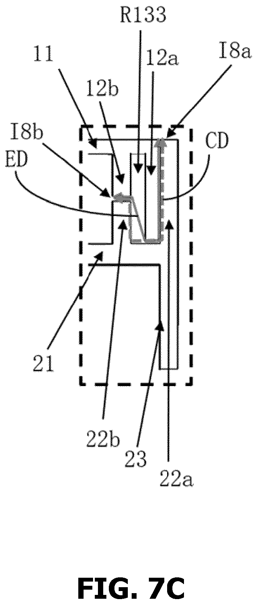

In the third case of the boss encapsulation structure as shown in FIG. 7C, each side of the two sides of the first shell provided with the first boss includes two first bosses 12a and 12b, and each side of the two sides of the second shell provided with the second boss includes two second bosses 22a and 22b. An end of the inner first boss 12b of the two first bosses that is disposed on an inner side is jointed with an end of the inner second boss 22b in the two second bosses that is disposed on an inner side (for example, to form a boss interface I8b), and an end of the outer first boss 12a of the two first bosses that is disposed on an outer side is jointed with the second plate-like structure 21 of the second shell; the outer second boss 22a in the two second bosses that is disposed on an outer side encapsulates from the outside the outer first boss 12a. In some embodiments, the outer second boss 22a may completely coat the outer first boss 12a, and may also partially coat the outer first boss 12a. In the third case, the outer second boss 22a completely coats the outer surface of the outer first boss 12a, that is, an end of the outer second boss 22a is substantially flush with the outer surface of the first plate-like structure 11 of the first shell (for example, to form a boss interface I8a). At this point, the creepage distance CD and the electrical clearance distance ED constructed by the first shell and the second shell are as shown in FIG. 7C. Compared with the embodiments as shown in FIG. 5 and FIGS. 6A to 6D, the creepage distance CD and the electrical clearance distance ED constructed by the boss encapsulation structure in the third case are also significantly increased. In the embodiment shown in FIG. 7C, for example, assembling gaps may be formed correspondingly at least at the boss interface I8b, at a joining portion of the end of the outer first boss 12a and the second plate-shaped structure 21 of the second shell, and at an encapsulating portion of the outer second boss 22a and the outer first boss 12a, which may be combined with the first air gap layer to form a creepage path on the first structure ST1 that extends from the inner shielding layer to the outer shielding layer (see FIG. 2A). For example, the space through which the creepage distance CD extends as shown by the dashed line in FIG. 7C is the creepage path.

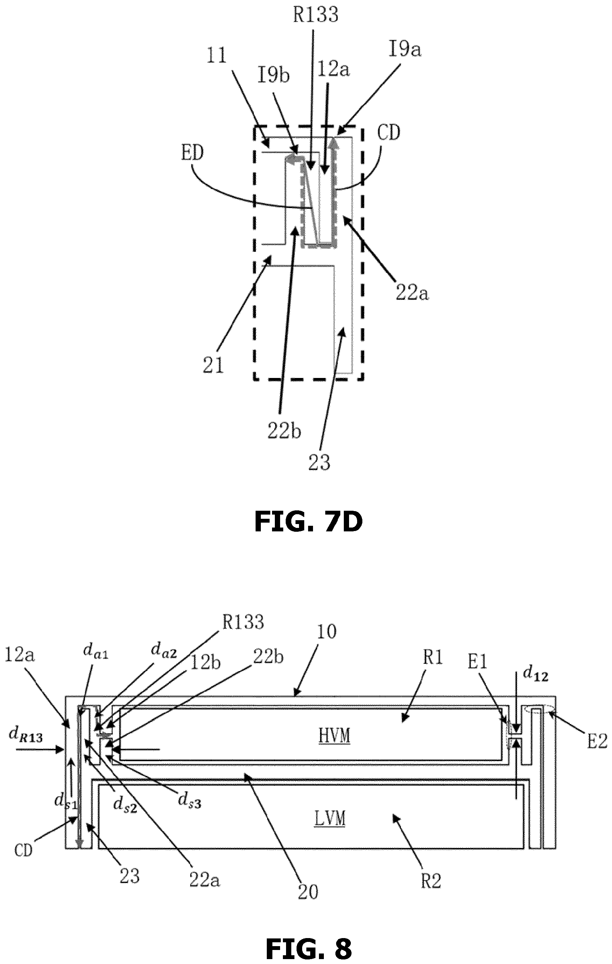

In the second case of the boss encapsulation structure as shown in FIG. 7D, each side of the two sides of the first shell provided with the first boss includes one first boss 12a, and each side of the two sides of the second shell provided with the second boss includes two second bosses 22a and 22b. An end of the inner second boss 22b in the two second bosses that is disposed on an inner side is jointed with the first plate-like structure 11 of the first shell (for example, to form a boss interface I9b), and an end of the first boss 12a is jointed with the second plate-like structure 21

of the second shell; the outer second boss 22a in the two second bosses that is disposed on an outer side encapsulates from the outside the first boss 12a. In some embodiments, the outer second boss 22a may completely coat the first boss 12a, and may also partially coat the first boss 12a. In the fourth case, the outer second boss 22a completely coats the outer surface of the first boss 12a, that is, an end of the second boss 22a is substantially flush with the outer surface of the first plate-like structure 11 of the first shell (for example, to form a boss interface I9a). At this point, the creepage distance CD and the electrical clearance distance ED constructed by the first shell and the second shell are as shown in FIG. 7D. Compared with the embodiments as shown in FIG. 5 and FIGS. 6A to 6D, the creepage distance CD and the electrical clearance distance ED constructed by the boss encapsulation structure in the fourth case are also significantly increased. In the embodiment shown in FIG. 7D, for example, assembling gaps may be formed correspondingly at least at the interface I9b of the boss, at a joining portion of the end of the first boss 12a with the second plate-shaped structure 21 of the second shell, and at an encapsulating portion of the outer second boss 22a and the first boss 12a, which may be combined with the first air gap layer to form a creepage path on the first structure ST1 that extends from the inner shielding layer to the outer shielding layer (see FIG. 2A). For example, the space through which the creepage distance CD extends as shown by the dashed line in FIG. 7C is the creepage path.

It may be understood that in the present disclosure, the bosses provided on two sides of the first shell and the second shell may be of the same structure or a combination of different structures. For example, the left side of the first shell may be provided with a boss flush structure, while the right side may be provided with a boss encapsulation structure or a boss staggered structure, for example, which is not intended to limit the present disclosure.

FIG. 8 is a structural schematic diagram of an electronic device including a shielded insulating shell having a boss encapsulation structure according to the present disclosure, showing a boss insulation structure in which the outer first boss of the first shell coats the outer second boss of the second shell. FIG. 9 shows the variation of the electric fields E1 and E2 at two positions in FIG. 8 with the distance $d_{12}$ between the ends of the inner first boss and the inner second boss.

As shown in FIG. 8, each side of the two sides of the first shell 10 provided with the first boss includes two first bosses 12a and 12b, and each side of the two sides of the second shell provided with the second boss 20 includes two second bosses 22a and 22b. An end of the inner first boss 12b disposed on an inner side is abutted with an end of the second boss 22b disposed on an inner side, and the outer first boss 12a that is disposed on an outer side encapsulates from the outside the outer second boss 22a that is disposed on an outer side. The total thickness R1 of the side wall of the first cavity is $d_{R13} = d_{s1} + d_{s2} + d_{s3} + d_{a1} + d_{a2}$, which shall meet the formula

$$\varepsilon_{r0} \times \left( \frac{d_{s1}}{\varepsilon_{r1}} + \frac{d_{s2}}{\varepsilon_{r2}} + \frac{d_{s3}}{\varepsilon_{r3}} \right) + d_{a1} + d_{a2} \geq \frac{U}{E_b}$$

, where, $d_{s1}$, $d_{s2}$, $d_{s3}$ are the solid insulation thickness of the outer first boss 12a of the first shell, the solid insulation thickness of the outer second boss 22a of the second shell, and the solid insulation thickness of the inner second boss 22b of the second shell, respectively; $d_{a1}$, $d_{a2}$ are the air gap thickness between the outer first boss 12a of the first shell and the outer second boss 22a of the second shell, the air gap thickness between the outer second boss 22a of the second shell and the inner second boss 22b of the second shell (i.e., the thickness of the first side wall air gap layer R133), respectively; $\varepsilon_{r0}$ is the dielectric constant of the filling gas in the air gap; $\varepsilon_{r1}$, $\varepsilon_{r2}$, $\varepsilon_{r3}$ are the dielectric constant of the outer first boss 12a of the first shell, the outer second boss 22a of the second shell, and the inner second boss 22b of the second shell, respectively; $U$ is the potential difference between the first side wall shielding layer (for example, provided on the inner surfaces of the inner first boss 12b and the inner second boss 22b) and the second side wall shielding layer (for example, provided on the outer surfaces of the outer first boss 12a and the outer second boss 22a); $E_b$ is the breakdown field strength of air. As shown in FIG. 8, the maximum electric field is the electric field E1 in the air inside the ends of the inner first boss 12b and the inner second boss 22b and the electric field E2 at the uppermost position in the air gap between the outer first boss 12a and the outer second boss 22a. FIG. 9 shows the variation of the electric fields E1 and E2 at two positions in FIG. 8 with the distance $d_{12}$ between the ends of the inner first boss 12b and the inner second boss 22b. In order to minimize the electric fields E1 and E2 and meanwhile support the first shell and the second shell, the designed distance $d_{12}$ may be selected to be less than 1mm. It should be noted that, for the general case that the side wall of one side of the first cavity has totally k bosses in the horizontal direction from the inside to the outside, the total thickness $d_{R13}$ of the side wall is $d_{s1} + d_{s2} +$

$$\varepsilon_{r0} \times \left( \frac{d_{s1}}{\varepsilon_{r1}} + \frac{d_{s2}}{\varepsilon_{r2}} + \cdots + \frac{d_{sk}}{\varepsilon_{rk}} \right) + d_{a1} +$$

$\cdots d_{sk} + d_{a1} + d_{a2} + \cdots + d_{a(k-1)}$, which needs to meet the formula

$$d_{a2} + \cdots + d_{a(k-1)} \geq \frac{U}{E_b}$$

, where, the relative dielectric constants of the bosses are $\varepsilon_{r1}$, $\varepsilon_{r2}$, $\cdots$, $\varepsilon_{rk}$ in order, and the solid insulation thicknesses are $d_{s1}$, $d_{s2}$, $\cdots$, $d_{sk}$ in order; the air gap thicknesses between the bosses are $d_{a1}$, $d_{a2}$, $\cdots$, $d_{a(k-1)}$ in order, and the relative dielectric constant of air is $\varepsilon_{r0}$; the breakdown field strength of air is $E_b$, and the potential difference between the first side wall shielding layer and the second side wall shielding layer is $U$.

As shown in FIG. 3, in the first preferred shielded insulating shell of the present disclosure, any side wall R13 of the first cavity R1 includes at least one of the first bosses (for example, first bosses 12a and 12b) and at least one of the second bosses (for example, second bosses 22a and 22b), wherein at least a boss is disposed that is in the innermost position, which is the innermost boss (for example, first boss 12b, second boss 22b). Moreover, the first side wall shielding layer R131 in any side wall R13 is disposed on the inner surface of the innermost boss. Furthermore, the upper wall shielding layer R111 in the upper wall R11 of the first cavity R1 is disposed on the inner surface of the upper wall insulating layer R113, and the lower wall shielding layer R121 in the lower wall R12 of the first cavity R1 is disposed on the inner surface of the lower wall insulating layer R123; the upper wall shielding layer R111, the lower wall shielding layer R121 and the first side wall shielding layer R131 form an inner shielding layer disposed on the inner side, for example, a high voltage shielding layer HSL, for example, to shield the high voltage module HVM which is accommodated in the first cavity R1. The second side wall shielding layer E135 in each side wall R13 is disposed on the outer surface of the outermost boss. The upper wall shielding layer R112 in the upper wall R11 of the first cavity R1 is disposed on the outer surface of the upper wall insulating layer R113, and the lower wall shielding layer R122 in the lower wall R12 of the first cavity R1 is disposed on the outer surface of the lower wall insulating layer R123; the upper wall shielding layer R112, the lower wall shielding layer R122 and the second side wall shielding layer R135 form an outer shielding layer disposed on the outer side, for example, a low voltage shielding layer LSL. A second cavity shielding layer R21 is provided on the insulating surface adjacent to the low voltage module LVM, which may also be a low voltage shielding layer LSL, for example, to shield the low voltage module LVM accommodated in the second cavity R2.

FIG. 10 is a structural schematic diagram of the electronic device including the second preferred shielded insulating shell according to a embodiment of the present disclosure. Unlike the shielded insulating shell as shown in FIG. 3, in the present embodiment, the first side wall shielding layer R131 is disposed inside the innermost boss (for example, the first boss 12b, the second boss 22b), that is, insulated. Furthermore, a further upper wall insulating layer R114 is formed on the inner surface of the upper wall shielding layer R111 in the upper wall R11 of the first cavity R1, and a further lower wall insulating layer R124 is formed on the inner surface of the lower wall shielding layer R121 in the lower wall R12 of the first cavity R1. The first side wall shielding layer R131, the upper wall shielding layer R111, and the lower wall shielding layer R121 form a high voltage shielding layer HSL, for example, to shield the high voltage module HVM which is accommodated in the first cavity R1. That is, a solid insulating layer is also provided inside the high voltage shielding layer HSL. Or, in another embodiment, part of the high voltage shielding layer HSL may be provided on the inner surface of the innermost boss (for example, the high voltage shielding layer HSL in the left side wall R13 may be provided on the inner surface of the innermost bosses 12b and 22b, that is, on the solid insulation surface); part of the high voltage shielding layer HSL is provided inside the solid insulation of the innermost boss (for example, the high voltage shielding layer HSL of the right side wall R13 is provided inside the innermost bosses 12b and 22b, that is, insulated and coated by the innermost bosses 12b and 22b, that is, provided inside the solid insulation). Of course, it may be understood that in other embodiments, the high voltage shielding layer HSL in a different position may also be combined in different structures of "disposed on the solid insulation surface" and "disposed inside the solid insulation". Preferably, in order to make full use of the withstand voltage capability of the solid insulation, the high voltage shielding layer HSL needs to be provided on the inner surface of the innermost boss or inside the solid insulation of the innermost boss.

When the high voltage shielding layer HSL is disposed on the solid insulation surface, the shell may be preformed, so that the inner surface of the preformed shell is an insulating layer, and then the high voltage shielding layer is sprayed on the surface of the insulating layer, so that the high voltage shielding layer is disposed on the solid insulation surface, thereby reducing the difficulty of casting the shell. More specifically, taking the first shell 10 in FIG. 3 as an example, the inner surface of the innermost boss 12b of the first shell 10 may be an insulating layer, and then the high voltage shielding layer HSL (i.e., the first side wall shielding layer R131) may be sprayed on the surface of the insulating layer, so that the high voltage shielding layer HSL may be disposed on the solid insulation surface of the innermost boss 12b.

When the high voltage shielding layer HSL is disposed inside the solid insulation, a solid insulating layer (i.e., another insulating layer) may be sprayed on the surface of an insulating layer of the preformed shell after the high voltage shielding layer is sprayed on the surface; The insulating layer may also be directly coated on the inner surface of the high voltage shielding layer by fixing the high voltage shielding layer in a preset position during the pouring process. The high voltage shielding layer is disposed inside the solid insulation, which may reduce the electric field stress in the edge air of the high voltage shielding layer and improving the partial discharge level of the insulating shell. More specifically, taking the first shell 10 in FIG. 10 as an example, the inner surface of the first shell 10 may be an insulating layer (for example, corresponding to the upper wall insulating layer R113), then a high voltage shielding layer HSL (for example, corresponding to the upper wall shielding layer R111) may be sprayed on the surface of the insulating layer, and then a solid insulating layer (i.e., to form a further upper wall insulating layer R114) may be sprayed on the surface of the high voltage shielding layer HSL.

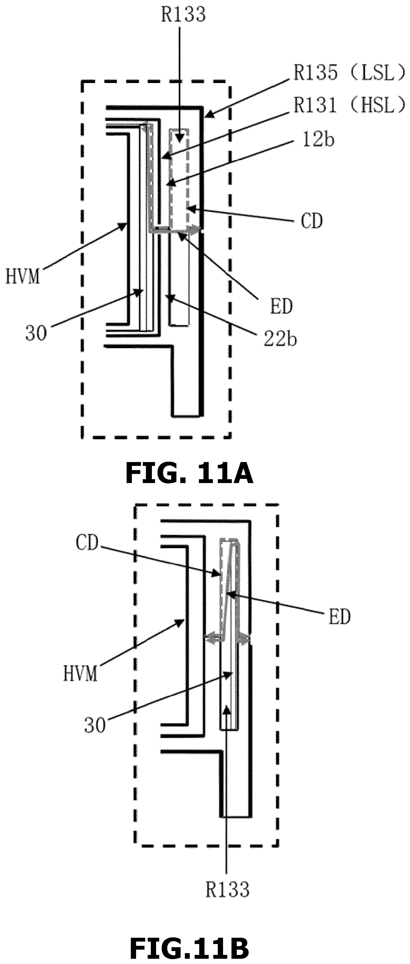

In the present disclosure, the shielded insulating shell of the present disclosure may further increase the electrical clearance distance ED and/or the creepage distance CD by providing an independent insulating layer, thereby reducing the shell volume and improving the power density of the system. In one embodiment, FIG. 11A shows the structure of the third preferred shielded insulating shell according to a embodiment of the present disclosure. When the first side wall shielding layer R131 is disposed inside the innermost boss (for example, the first boss 12b, the second boss 22b), an independent insulating layer 30 may be provided between the innermost boss and the high voltage module HVM. In another embodiment, FIG. 11B shows the structure of the fourth preferred shielded insulating shell according to a embodiment of the present disclosure, wherein an independent insulating layer 30 may be provided in the first side wall air gap layer R133. In the present disclosure, the independent insulating layer 30 may be made of the same or different insulating material as the first side wall insulating layer R132, the second side wall insulating layer R134, the upper wall insulating layer R113 and the lower wall insulating layer R123, such as epoxy resin, polyurethane or silicone rubber. The thickness of the independent insulating layer shall not be less than $U/E_{b\_s}$. Where, U is the potential difference between the first side wall shielding layer R131 and the second side wall shielding layer R135, and $E_{b\_s}$ is the breakdown field strength of the independent insulating layer 30. In the present disclosure, the independent insulating layer may be fixed to the adjacent boss by studs, or may be directly adhered to the surface of the adjacent boss or plate-like structure, which is not intended to limit the present disclosure.

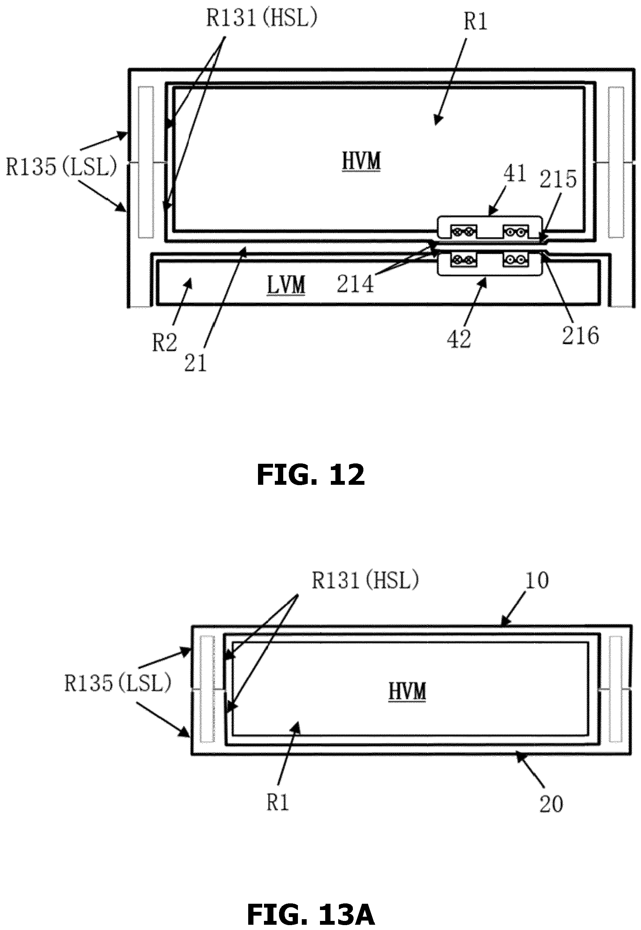

FIG. 12 shows the structure of the electronic device including the fifth preferred shielded insulating shell according to a embodiment of the present disclosure, wherein at least part of the second plate-like structure 21 of the second shell may form a concave portion on the plate-like structure for disposing a primary magnetic core and a secondary magnetic core of a transformer. In the embodiment as shown in FIG. 12, at least part of the second plate-like structure 21 of the second shell respectively forms a concave portion 215, 216 on an upper side and a lower side of the plate-like structure for disposing a primary magnetic core 41 and a secondary magnetic core 42 of a transformer. The thickness of the insulating layer corresponding to the concave portions 215 and 216 may be reduced, and the shielding layer covered on the surface of the insulating layer at the reduced thickness portion may preferably be a semiconductive layer. The surface resistance may preferably range from 1 kohm to 500 kohm. The insulation thickness of the concave portions 215 and 216 is reduced, which may enhance the coupling of the primary and secondary sides of the transformer and improve the efficiency of the transformer. Controlling the surface resistance of the semiconductive layer may also shield the electric field and reduce the magnetic loss.

FIG. 13A shows the structure of the electronic device including the sixth preferred shielded insulating shell according to a embodiment of the present disclosure, wherein the shielded insulating shell assembled by the first shell 10 and the second shell 20 is only provided with a first cavity R1, for example, to accommodate the high voltage module HVM. In the present embodiment, the bosses on the first shell 10 and the second shell 20 are both provided on the lower side of the upper wall of the first cavity R1 and the upper side of the lower wall of the first cavity R1. This structure is applicable to the case where there is only a high voltage module HVM in the electronic device.

In addition, in other embodiments of the present disclosure, some bosses may be provided on the upper side of the upper wall of the first cavity R1 or the lower side of the lower wall of the first cavity R1 to facilitate connection with a cabinet or fixation of one or more low voltage modules.

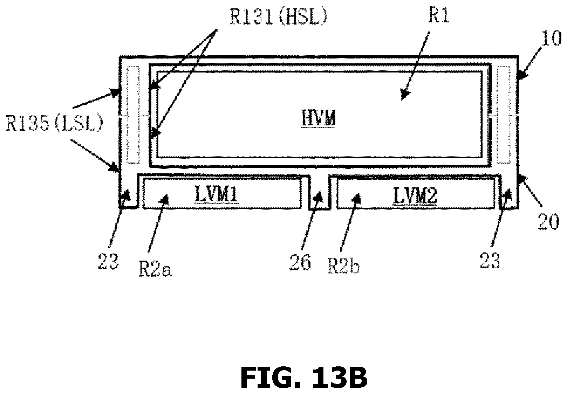

FIG. 13B shows the structure of the electronic device including the seventh preferred shielded insulating shell according to a embodiment of the present disclosure, wherein the first cavity R1 may accommodate the high voltage module HVM, and the lower side of the second shell 20 also has two third bosses 23; a third intermediate boss 26 is disposed between the two third bosses 23 to separate the second cavity R2 into two second sub-cavities R2a and R2b, which may accommodate the low voltage modules LVM1 and LVM2, respectively.

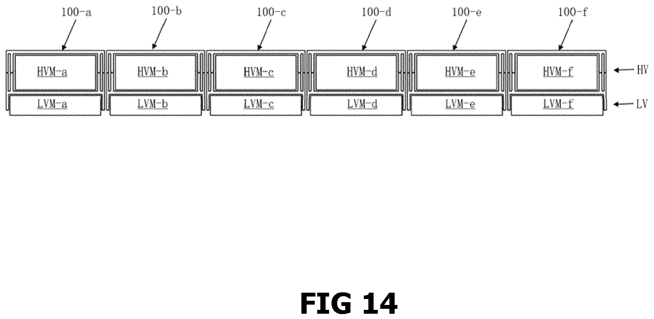

FIG. 14 shows the structure of the electronic device including the eighth preferred shielded insulating shell according to a embodiment of the present disclosure, wherein a plurality of independent insulating shells 100a, 100b,......,100f are placed side by side. In the embodiment as shown in FIG. 14, each independent insulating shell (for example, 100a/100b/....../100f) includes a high voltage side cavity disposed at the high voltage side HV to accommodate the high voltage module (for example, HVM-a/HVM-b/ ...... /HVM-f) and a low voltage side cavity disposed at the low voltage side LV to accommodate the low voltage module (for example, LVM-a/LVM-b/....../LVM-f). The high voltage modules HVM-a, HVM-b, ......, HVM-f in these insulating shells 100a, 100b,......,100f may be connected in cascade with a single-phase electric power to form a higher voltage level system; may also be connected with the three-phase electric power, and is applicable to forming a three-phase system. For example, the high voltage modules HVM-a and HVM-b may be electrically connected to phase A of the three-phase system, the high voltage modules HVM-c and HVM-d may be electrically connected to phase B of the three-phase system, and the high voltage modules HVM-e and HVM-f may be electrically connected to phase C of the three-phase system. The low voltage side outputs (for example, low voltage modules LVM-a, LVM-b, ......, LVM-f) may be connected in parallel, in series or output separately to adapt to different voltage level applications.

In the embodiment as shown in FIG. 14, these independent insulating shells 100a, 100b, ......, 100f have different structures, which may be, for example, the structure of the shielded insulating shell as shown in FIG. 3. In other embodiments, these independent insulating shells 100a, 100b, ......, 100f may also be the structure of the shielded insulating shell as shown in other figures. Moreover, it may be understood that, these independent insulating shells 100a, 100b, ......, 100f have different structures, which is not intended to limit the present disclosure. In some embodiments of the present disclosure, the sizes of the high voltage side cavities of the insulating shells 100a, 100b, ......, 100f may be the same or different, and the sizes of the low voltage side cavities of the insulating shells 100a, 100b, ......, 100f may be the same or different, which is likewise not intended to limit the present disclosure.

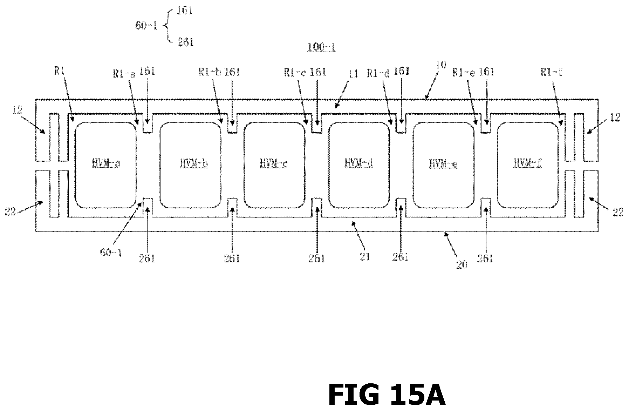

FIG. 15A shows the structure of the electronic device including the ninth preferred shielded insulating shell 100-1 according to a embodiment of the present disclosure. The first shell 10 further includes at least a first intermediate boss 161 between the first bosses 12 on two sides in addition to the first plate-like structure 11 and the first bosses 12 on two sides. The second shell 20 includes at least a second intermediate boss 261 between the second bosses 22 on two sides in addition to the first plate-like structure 21 and the second bosses 22 on two sides. The at least a second intermediate boss 261 and the at least a first intermediate boss 161 are oppositely disposed and cooperate to form at least a first intermediate isolation portion, which may be, for example, a first isolation structure 60-1 formed by one first intermediate boss 161 and one second intermediate boss 261 oppositely disposed, and these first isolation structures 60-1 may isolate the first cavity R1 into at least two first sub-cavities; a high voltage module may be placed in each of the first sub-cavities. Moreover, at least two high voltage modules may be disposed in the first cavity R1 to connect with the single-phase electric power in series or in parallel.

In the embodiment as shown in FIG. 15A, the shielded insulating shell 100-1 includes five first isolation structures 60-1, to isolate the first cavity R1 into six first sub-cavities R1-a, R1-b, ......, R1-f, and to accommodate the high voltage modules HVM-a, HVM-b, ......, HVM-f. The first intermediate boss 161 and the second intermediate boss 261 forming the first isolation structure 60-1 do not contact each other. In the embodiment as shown in FIG. 15A, these high voltage modules HVM-a, HVM-b, ......, HVM-f may be connected in cascade with a single-phase electric power to form a higher voltage level system; may also be connected with the three-phase electric power, and is applicable to forming a three-phase system; for example, the two high voltage modules HVM-a and HVM-b in the first group on the left, the two high voltage modules HVM-c and HVM-d in the second group in the middle, and the two high voltage modules HVM-e and HVM-f in the third group on the right may be electrically connected to the single-phase electric power, respectively, and for example, these high voltage modules are electrically connected to phase A, phase B and phase C of the three-phase system. However, it may be understood that, in other embodiments, the number of the first intermediate isolation portions included in the shielded insulating shell 100-1 may be another number.

In other embodiments of the present disclosure, only one of the first shell 10 and the second shell 20 may be provided with an intermediate boss, while the other shell may not be provided with an intermediate boss. In the present disclosure, the intermediate bosses (such as the first intermediate boss 161 and the second intermediate boss 261) may position the high voltage modules, increase the creepage distance between the high voltage modules, and reduce the shell volume.

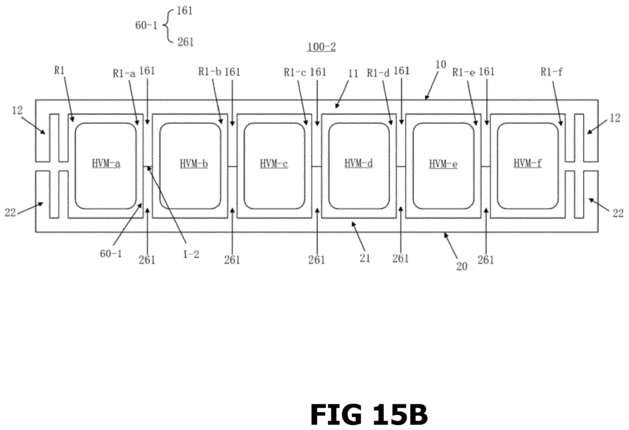

FIG. 15B shows the structure of the electronic device including the eleventh preferred shielded insulating shell 100-3 according to a embodiment of the present disclosure, which is different from the embodiment as shown in FIG. 15A in that: the first intermediate boss 161 and the second intermediate boss 261 forming the first isolation structure 60-1 are in contact with each other, that is, a boss interface 1-2 is formed therebetween. The shielded insulating shell 100-2 as shown in FIG. 15B is applicable to the case where the voltage difference between the high voltage modules is high.

In other embodiments of the present disclosure, the first intermediate boss 161 and/or the second intermediate boss 261 forming the first intermediate isolation portion may also disposed as a convex structure including two or more intermediate bosses, in order to further increase the creepage distance. More preferably, there may also be an intermediate air gap between two or more intermediate bosses.

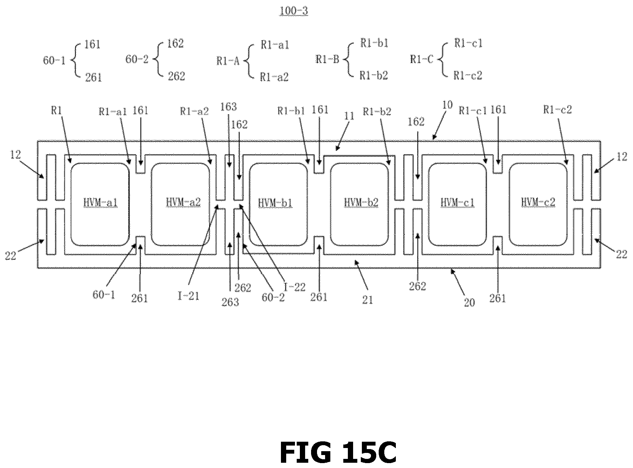

FIG. 15C shows the structure of the electronic device including the eleventh preferred shielded insulating shell 100-3 according to a embodiment of the present disclosure. The high voltage module is disposed in the first cavity to be connected with the three-phase electric power, which is applicable to the three-phase system. The shielded insulating shell 100-3 of the present embodiment is different from the shielded insulating shell 100-1 as shown in FIG. 15A in that, the first intermediate isolation portion includes a second isolation structure 60-2 formed by two first intermediate bosses 161 and two second intermediate bosses 261 oppositely disposed in addition to the first isolation structure 60-1, wherein the first cavity R1 is separated into a plurality of first sub-cavities R1-a1, R1-a2, R1-b1, R1-b2, R1-c1 and R1-c2 by the first isolation structure 60-1 and the second isolation structure 60-2; two adjacent first sub-cavities R1-b1 and R1-b2 in the first group on the left form a phase cavity R1-A of phase A, and two adjacent first sub-cavities R1-b1 and R1-b2 in the second group in the middle form a phase cavity R1-B of phase B; two adjacent first sub-cavities R1-c1 and R1-c2 in the third group on the right form a phase cavity R1-C of phase C, and the phase cavities R1-A, R1-B and R1-C in different phases are isolated by the second isolation structure 60-2. The plurality of first sub-cavities R1-a1, R1-a2, R1-b1, R1-b2, R1-c1 and R1-c2 may be respectively used to accommodate one high voltage module HVM-a1, HVM-a2, HVM-b1, HVM-b2, HVM-c1 and HVM-c2, wherein, every two high voltage modules from left to right form one phase, i.e., two high voltage modules HVM-a1 and HVM-a2 in the first group on the far left are electrically connected to phase A of the three-phase system, two high voltage modules HVM-b1 and HVM-b2 in the second group in the middle are electrically connected to phase B of the three-phase system, and two high voltage modules HVM-c1 and HVM-c2 in the third group on the far right are electrically connected to phase C of the three-phase system.

In the present disclosure, the phase cavity of a single phase may accommodate at least a high voltage module. For example, in the embodiment as shown in FIG. 15C, two high voltage modules are placed in the phase cavity of each phase. It may be understood that, in other embodiments, three or more high voltage modules may be disposed in the phase cavity of each phase, which is not intended to limit the present disclosure. Preferably, a plurality of high voltage modules in a single phase may be connected in series to increase the voltage level.

In some embodiments of the present disclosure, preferably, a second subcavity may be further formed below the outside of the first cavity R1, to accommodate the low voltage module. More preferably, the high voltage module of the corresponding phase and the low voltage module of the corresponding phase are disposed corresponding to each other. In some embodiments, a plurality of low voltage modules in a single phase may be connected in series, in parallel, or output separately. The three-phase circuits of the three-phase system may be in delta connection or star connection.

In some embodiments of the present disclosure, preferably, the second isolation structure 60-2 may be an intermediate boss interface flush structure (the more specific structure may be combined with the "boss interface flush structure" as shown in FIG. 5), an intermediate boss interface staggered structure (the more specific structure may be combined with several "boss interface staggered structures" as shown in FIGS. 6A to 6D) and an intermediate boss encapsulation structure (the more specific structure may be combined with any one more of several "boss covering structures" as shown in FIGS. 7A to 7D).

In the embodiment as shown in FIG. 15C, the second isolation structure 60-2 is, for example, an intermediate boss interface flush structure. The two intermediate boss interfaces 1-21 and 1-22 are formed by two first intermediate bosses 161 and two second intermediate bosses 261 disposed oppositely, and the two intermediate boss interfaces 1-21 and I-22 are disposed at the same height.

In the embodiment as shown in FIG. 15C, the two intermediate boss interfaces I-21, I-22, for example, may be an air gap layer (i.e., an air gap layer is formed at the joint of the two first intermediate bosses 161 and the two second intermediate bosses 261). However, it may be understood that, in other embodiments, the joints of the two first intermediate bosses 161 and the two second intermediate bosses 261 may also be in contact with each other, which is likewise not intended to limit the present disclosure.

In the embodiment as shown in FIG. 15C, there is an intermediate air gap 163 between two first intermediate bosses 161, and there is also an intermediate air gap 263 between two second intermediate bosses 261.

In the embodiments as shown in FIG. 15A to 15C, the shielded insulating shells 100-1, 100-2 and 100-3 are structures in which a plurality of high voltage modules is disposed in a single shell, and the thickness and weight of the side wall may be reduced through series connection of a plurality of high voltage modules, thereby reducing the whole shell volume.

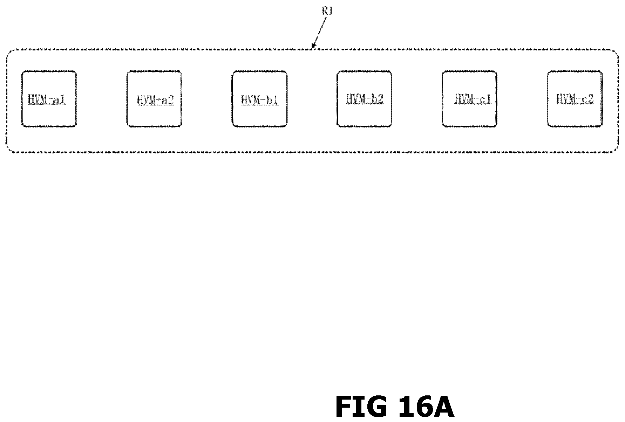

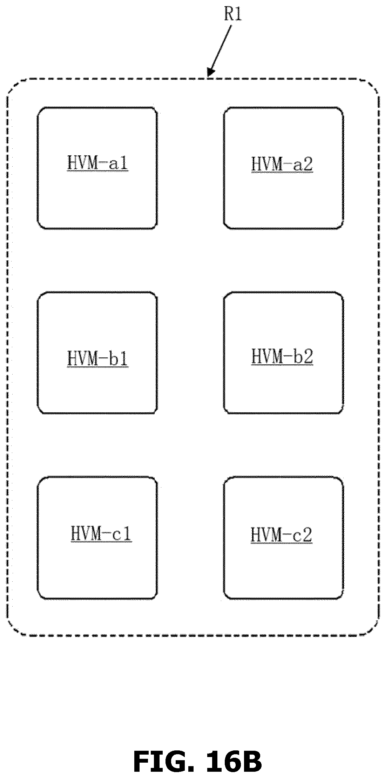

FIGS. 16A to 16B show the layout of a plurality of high voltage modules in the first cavity R1 according to the present disclosure. As shown in FIG. 16A, a plurality of high voltage modules is disposed in a horizontal line in the lateral direction. For example, the two high voltage modules HVM-a1 and HVM-a2 in the first group, the two high voltage modules HVM-b1 and HVM-b2 in the second group, and the two high voltage modules HVM-c1 and HVM-c2 in the third group are arranged in order from left to right in the lateral direction. Or, as shown in FIG. 16B, a plurality of high voltage modules is disposed in a matrix. For example, the two high voltage modules HVM-a1 and HVM-a2 in the first group, the two high voltage modules HVM-b1 and HVM-b2 in the second group, and the two high voltage modules HVM-c1 and HVM-c2 in the third group are arranged in order from up to down in the longitudinal direction. Thus, different layouts may adapt to the size requirements of different shell structures.

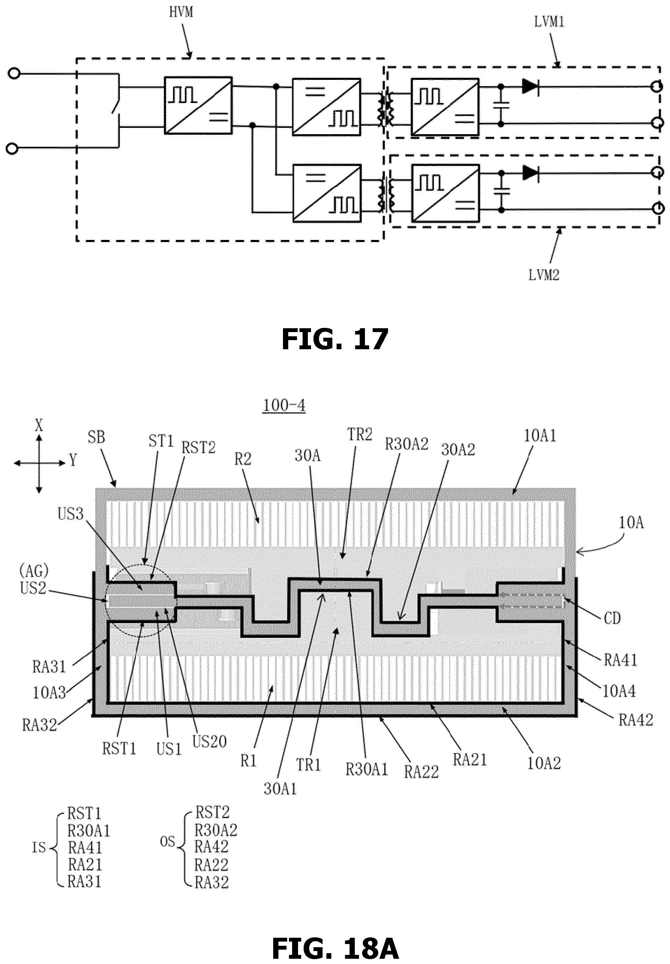

FIG. 17 shows the circuit structure inside the one-driven-two power unit, which is capable to the shielded insulating shell structure with two second sub-cavities on the low voltage side as shown in FIG. 13B. For example, the specific circuit structure is one high voltage circuit plus two low voltage circuit outputs, wherein the one high voltage circuit may be integrated into one high voltage module HVM, which may be which is accommodated in the first cavity R1 as shown in FIG. 13B, for example; the two low voltage circuit outputs may be integrated into low voltage modules LVM1 and LVM2 respectively, which may be accommodated in the second sub-cavities R2a and R2b as shown in FIG. 13B, for example. the two low voltage circuit outputs may be connected in series, in parallel or output separately, and are applicable to different requirements for the output voltage levels.

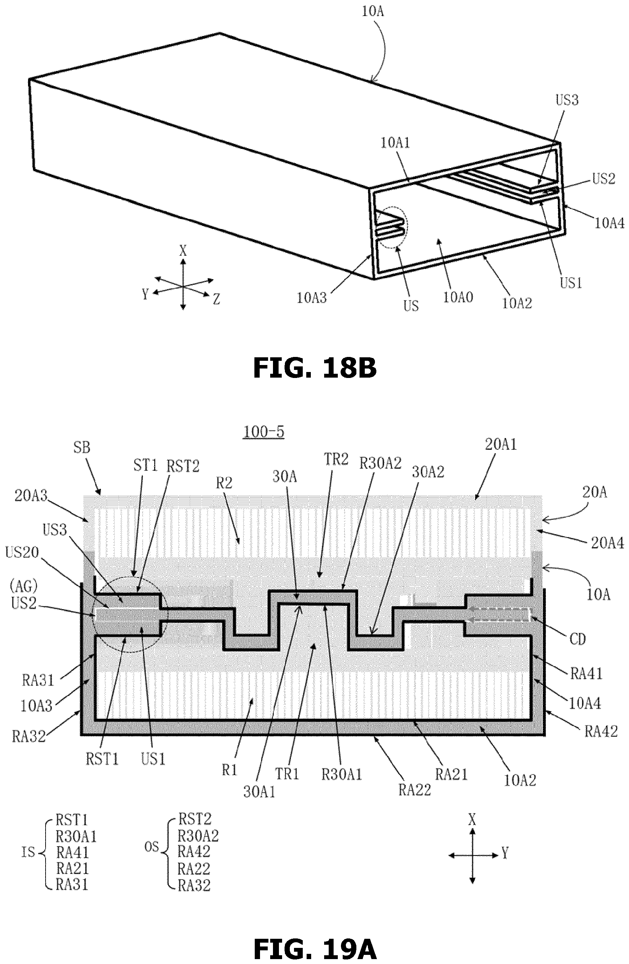

As shown in FIGS. 18A to 18B, FIG. 18A shows the structure of an electronic device of a shielded insulating shell 100-4 according to the twelfth preferred embodiment of the present disclosure, and FIG. 18B shows the three-dimensional structure of the first shell 10A of the shielded insulating shell in FIG. 18A. In this embodiment, the shielded insulating shell 100-4 may include the shell body SB and the first structure ST1. The shell body SB may include a first shell 10A and a separator plate 30A. The first shell 10A includes an upper wall 10A1 and a lower wall 10A2 that are opposite to each other, and two side walls 10A3 and 10A4 that are opposite to each other. The two side walls 10A3 and 10A4 extend inward in a second direction Y (such as the horizontal direction in FIG. 18A) to form a convex structure, such as a U-shaped groove structure US. Each U-shaped groove structure US includes two groove walls US1 and US3 that are opposite to each other, and a groove US2 disposed between the two groove walls US1 and US3. The separator plate 30A is installed by fitting to the U-shaped groove structure US to form the first structure ST1, and separates an internal space 10A0 of the first shell 10A to form a first cavity R1 and a second cavity R2. Preferably, in this embodiment, the separator plate 30A is installed in the groove US2 of the U-shaped groove structure US by inserting its two ends in the U-shaped groove structure US, without providing the shielding layer on the inserted parts of the two ends of the separator plate 30A. Moreover, the gap portion remained in groove US2 of the inserted U-shaped groove structure US form the first air gap layer of the first structure ST1 correspondingly.

In this embodiment, the two side walls 10A3 and 10A4 of the first shell 10A are provided with first side wall shielding layers RA31 and RA41 disposed near the first cavity R1, for example, on the inner surface corresponding to the first cavity R1. The two side walls 10A3 and 10A4 of the first shell 10A are provided with second side wall shielding layers RA32 and RA42 far away from the first cavity R1, for example, arranged on the outer surface corresponding to the first cavity R1. The lower wall 10A2 of the first shell 10A is provided with an inner lower wall shielding layer RA21 disposed near the first cavity R1, for example, on the inner surface corresponding to the first cavity R1. The lower wall 10A2 of the first shell 10A is provided with an outer lower wall shielding layer RA22 far away from the first cavity R1, for example, arranged on the outer surface corresponding to the first cavity R1. On the outer surface of the first groove wall US1 of the two groove walls (US1 and US3) of each U-shaped groove structure US that corresponds to the first cavity R1, a first groove wall shielding layer RST1 is provided. On the outer surface of the second groove wall US3 of the two groove walls (US1 and US3) of each U-shaped groove structure US that corresponds to the second cavity R2, a second groove wall shielding layer RST2 is provided. The separator plate 30A is provided with a first separator plate shielding layer R30A1 disposed near the first cavity R1, for example, on an inner surface which is located correspondingly on the inner side of the first cavity R1. The separator plate 30A is provided with a second separator plate shielding layer R30A2 disposed far away from the first cavity R1, for example, on an outer surface which is located correspondingly on the outer side of the first cavity R1.

In this embodiment, the first groove wall shielding layer RST1, the first groove wall US1 of the U-shaped groove structure US, the gap portion remained in the groove US2 of the inserted U-shaped groove structure US, the second groove wall US3 of the U-shaped groove structure US, and the second groove wall shielding layer RST2 form, respectively, the first shielding layer, first insulating layer, first air gap layer, the second insulating layer, and the second shielding layer of the first structure ST1 correspondingly.

In this embodiment, the first groove wall shielding layer RST1, the first separator plate shielding layer R30A1, the first side wall shielding layers RA41 and RA31, and the inner lower wall shielding layer RA21 form the inner shielding layer IS disposed on the inner side of the first cavity R1 correspondingly. The first groove wall shielding layer RST1 is a part of the first shell, and the first separator plate shielding layer R30A1 is a part of the separator plate. The second groove wall shielding layer RST2, the second separator plate shielding layer R30A2, the second side wall shielding layers RA42 and RA32, and the outer lower wall shielding layer RA22 form the outer shielding layer OS disposed on the outer side of the first cavity R1 correspondingly. The second groove wall shielding layer RST2 is a part of the first shell, and the second separator plate shielding layer R30A2 is a part of the separator plate.

In this embodiment, gap portions are formed on both upper and lower sides of the two ends of the inserted separator plate 30A to form the first air gap layer of the first structure ST1 correspondingly. However, it may be understood that in some other embodiments of the present disclosure, the gap portions may be formed only on the upper side or the lower side of the two ends of the inserted separator plate 30A to form the first air gap layer of the first structure ST1 correspondingly, which does not limit the present disclosure specifically. In addition, for the convenience of installation, some auxiliary position-limiting structures, including but not limited to stop blocks, may be provided on the groove walls (including US 1 and/or US3) of the U-shaped groove structure US to limit the position during the insertion and installation of the separator plate 30A, so that the first air gap layer may be formed correspondingly in the first structure ST1 after the insertion and installation of the separator plate 30A, thereby constructing a sufficient creepage distance by utilizing the first air gap layer. In addition, in some embodiments, the position limitation during the insertion and installation of the separator plate 30A may be implemented by using the high voltage module in the first cavity.

In this embodiment, as shown in FIG. 18A, the gap portion formed between the two ends of the inserted separator plate 30A and the bottom portion of the groove US2 of the U-shaped groove structure US may be regarded as the assembling gap AG. This assembling gap AG may be combined with the first air gap layer (such as the gap portion formed correspondingly by the upper and lower sides of the two ends of the inserted separator plate 30A) to form a creepage path on the first structure ST1 that extends from the inner shielding layer IS to the outer shielding layer OS. For example, the space through which the creepage distance CD extends as shown by the dashed line in FIG. 18A is the creepage path.

Preferably, in some embodiments of the present disclosure, concave portions 30A1 and/or 30A2 may be further formed on the separator plate 30A, and may be adapted to part of the outer contours of some devices or modules accommodated correspondingly in the first cavity R1 and/or the second cavity R2, respectively. In this embodiment, the electronic device may be a power module, but the present disclosure is not limited to this. For example, the first cavity R1 may be used for accommodating the high voltage module TR1 while the second cavity R2 may be used for accommodating the low voltage module TR2, but the present disclosure is not limited to this.

Preferably, in some embodiments of the present disclosure, two adjacent shielding layers of multiple shielding layers (such as RST1, R30A1, RA41, RA31, RA21) which form the inner shielding layer IS are connected directly, or connected through conductive tapes or metal plates. Preferably, in some embodiments of the present disclosure, the first shell 10A and the separator plate 30A may be made of insulating materials, such as but not limited to epoxy resin, polyurethane, or silicone rubber.

Preferably, in some embodiments of the present disclosure, the first shell 10A may be integrally formed, for example.

For the shielded insulating shell 100-4 shown in FIGS. 18A to 18B, the installation process includes fixing the high voltage module TR1 and the low voltage module TR2 onto the separator plate 30A, but not limited thereto in the present disclosure, and then inserting them into the U-shaped groove structure US along the third direction Z, thereby fixing them on the first shell 10A. In this embodiment, the separator plate 30A and the first shell 10A are open structures which are detachable, allowing the high voltage module TR1 and low voltage module TR2 to be vertically installed on the separator plate 30A, making installation simpler and more convenient.

In the embodiments shown in FIGS. 18A to 18B, for example, the inner shielding layer IS may be a high voltage shielding layer and the outer shielding layer OS may be a low voltage shielding layer. The inner shielding layer IS as the high voltage shielding layer may be "disposed on a solid insulation surface" (for example, disposed on the inner surface of the first cavity R1), or "disposed inside a solid insulation" (for example, disposed inside the solid insulation near the first cavity R1, similar to the structure shown in FIG. 10). Of course, it may be understood that in other embodiments, the high voltage shielding layer at different positions may adopt different combinations of structures that are "disposed on the solid insulation surface" and "disposed inside the solid insulation", but the present disclosure is not specifically limited to it.

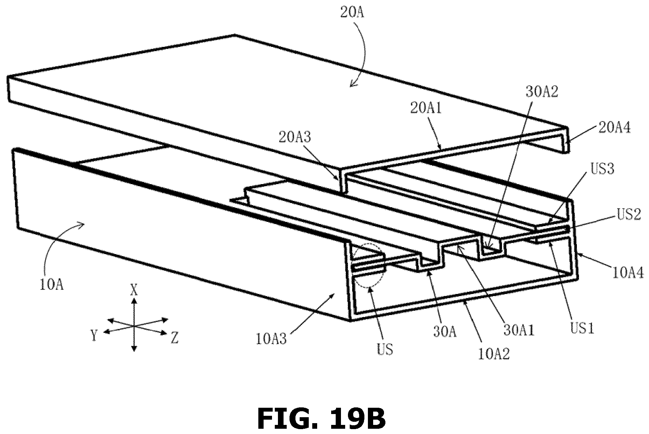

As shown in FIGS. 19A to 19B, FIG. 19A shows the structure of an electronic device including a shielded insulating shell 100-5 according to the thirteenth preferred embodiment of the present disclosure, and FIG. 19B shows the three-dimensional structure of the first shell 10A and the second shell 20A in a separated state of the shielded insulating shell in FIG. 19A. In this embodiment, the shielded insulating shell 100-5 may include the shell body SB and the first structure ST1. The shell body SB may only include the first shell 10A and the separator plate 30A. The first shell 10A may include a lower wall 10A2, and two side walls 10A3 and 10A4 disposed on opposite sides of the lower wall 10A2 and extending in the first direction X (such as the vertical direction in FIGS. 19A to 19B). The two side walls 10A3 and 10A4 extend inward in the second direction Y (such as the horizontal direction in FIGS. 19A to 19B) to form a convex structure, such as the U-shaped groove structure US. Each U-shaped groove structure US may include, for example, two groove walls US1 and US3 that are opposite to each other, and a groove US2 disposed between the two groove walls US1 and US3. The separator plate 30A is installed by fitting to the U-shaped groove structure US to form the first structure ST1, and forms the first cavity R1 together with the first shell 10A.

In this embodiment, the two side walls 10A3 and 10A4 of the first shell 10A are provided with first side wall shielding layers RA31 and RA41 disposed near the first cavity R1, for example, on the inner surface corresponding to the first cavity R1. The two side walls 10A3 and 10A4 of the first shell 10A are provided with second side wall shielding layers RA32 and RA42 far away from the first cavity R1, for example, arranged on the outer surface corresponding to the first cavity R1. The lower wall 10A2 of the first shell 10A is provided with an inner lower wall shielding layer RA21 disposed near the first cavity R1, for example, on the inner surface corresponding to the first cavity R1. The lower wall 10A2 of the first shell 10A is provided with an outer lower wall shielding layer RA22 far away from the first cavity R1, for example, arranged on the outer surface corresponding to the first cavity R1. The first groove wall US1 of the two groove walls (US1 and US3) of each U-shaped groove structure US that is positioned correspondingly on the inner side of the first cavity R1 is provided with a first groove wall shielding layer RST1 disposed near the first cavity R1, for example, on the outer surface of the first groove wall US1. The second groove wall US3 of the two groove walls (US1 and US3) of each U-shaped groove structure US that is positioned correspondingly on the outer side of the first cavity R1 is provided with a second groove wall shielding layer RST2 far away from the first cavity R1, for example, arranged on the outer surface of the second groove wall US3. The separator plate 30A is provided with a first separator plate shielding layer R30A1 disposed near the first cavity R1, for example, on an inner surface that is positioned correspondingly on the inner side of the first cavity R1. The separator plate 30A is further provided with a second separator plate shielding layer R30A2 disposed far away from the first cavity R1, for example, on an outer surface that is positioned correspondingly on the outer side of the first cavity R1.

In this embodiment, the first groove wall shielding layer RST1, the first groove wall US1 of the U-shaped groove structure US, the gap portion remained in the groove US2 of the inserted U-shaped groove structure US, the second groove wall US3 of the U-shaped groove structure US, and the second groove wall shielding layer RST2 form, respectively, the first shielding layer, first insulating layer, first air gap layer, the second insulating layer, and the second shielding layer of the first structure ST1 correspondingly.

In this embodiment, the first groove wall shielding layer RST1, the first separator plate shielding layer R30A1, the first side wall shielding layers RA41 and RA31, and the inner lower wall shielding layer RA21 form an inner shielding layer IS disposed on the inner side of the first cavity R1 correspondingly. The second groove wall shielding layer RST2, the second separator plate shielding layer R30A2, the second side wall shielding layers RA42 and RA32, and the outer lower wall shielding layer RA22 form an outer shielding layer OS disposed on the outer side of the first cavity R1 correspondingly.

Continuing with reference to FIGS. 19A to 19B, in a modified embodiment, the shell body SB may further include a second shell 20A. The second shell 20A may include, for example, an upper wall 20A1 and two side walls 20A3 and 20A4 disposed on opposite sides of the upper wall 20A1 and extending in the first direction X. In this modified embodiment, the first shell 10A and the second shell 20A are fitted and connected in a detachable manner. The two side walls 10A3 and 10A4 of the first shell 10A and the two side walls 20A3 and 20A4 of the second shell 20A are fitted and connected in an opposite way in the first direction X to form an internal space. The separator plate 30A may separate the internal space to form a first cavity R1 and a second cavity R2.

In the embodiments shown in FIGS. 19A to 19B, the separator plate 30A may be inserted and installed in the groove US2 of the U-shaped groove structure US through its two ends in a detachable way, without providing the shielding layer on the inserted portions of the two ends of the separator plate 30A. Moreover, the gap portion remained in the groove US2 of the inserted U-shaped groove structure US to form the first air gap layer of the first structure ST1 correspondingly. In the embodiments shown in FIGS. 19A to 19B, gap portions are formed on both upper and lower sides of the two ends of the inserted separator plate 30A to form the first air gap layer of the first structure ST1 correspondingly. However, it may be understood that in some other embodiments of the present disclosure, gap portions may be formed only on the upper side or the lower side of the two ends of the inserted separator plate 30A to form the first air gap layer of the first structure ST1 correspondingly, which does not limit specifically the present disclosure. In addition, for the convenience of installation, some auxiliary position-limiting structures, including but not limited to stop blocks, may be provided on the groove walls (including US1 and/or US3) of the U-shaped groove structure US to limit the position during the insertion and installation of the separator plate 30A, so that the first air gap layer may be formed correspondingly in the first structure ST1 after the insertion and installation of the separator plate 30A, thereby constructing a sufficient creepage distance by utilizing the first air gap layer.

In this embodiment, as shown in FIG. 19A, the gap portion formed between the two ends of the inserted separator plate 30A and the bottom portion of the groove US2 of the U-shaped groove structure US may be regarded as the assembling gap AG. This assembling gap AG may be combined with the first air gap layer (such as the gap portion formed correspondingly by the upper and lower sides of the two ends of the inserted separator plate 30A) to form a creepage path on the first structure ST1 that extends from the inner shielding layer IS to the outer shielding layer OS. For example, the space through which the creepage distance CD extends as shown by the dashed line in FIG. 19A is the creepage path.

Preferably, in some embodiments of the present disclosure, concave portions 30A1 and/or 30A2 may be further formed on the separator plate 30A, and may be adapted to part of the outer contours of some devices or modules accommodated correspondingly in the first cavity R1 and/or the second cavity R2, respectively. In this embodiment, the electronic device may be a power module, but the present disclosure is not limited to this. For example, the first cavity R1 may be used for accommodating the high voltage module TR1 while the second cavity R2 may be used for accommodating the low voltage module TR2, but the present disclosure is not limited to this. In addition, in some embodiments, the position limitation during the insertion and installation of the separator plate 30A may be implemented by using the high voltage module in the first cavity.

Preferably, in some embodiments of the present disclosure, two adjacent shielding layers of multiple shielding layers (such as RST1, R30A1, RA41, RA31, RA21) which form the inner shielding layer IS are connected directly, or connected through conductive tapes or metal plates.

Preferably, in some embodiments of the present disclosure, for example, the first shell 10A and the separator plate 30A may be made of insulating material, and the second shell 20A may be made of insulating material or metal material. The insulating materials may include, but are not limited to, epoxy resin, polyurethane, or silicone rubber.

Preferably, in some embodiments of the present disclosure, for example, the first shell 10A may be integrally formed, and the second shell 20A may be integrally formed.

For the shielded insulating shell 100-5 shown in FIGS. 19A to 19B, the installation process includes fixing the high voltage module TR1 onto the separator plate 30A, but not limited thereto in the present disclosure, and then inserting them into the U-shaped groove structure US along the third direction Z; and then fixing the low voltage module TR2 onto the separator plate 30A; and finally, fitting and installing the second shell 20A and the first shell 10A. In this embodiment, the separator plate 30A and the first shell 10A are detachable open structures, and the first shell 10A and the second shell 20A are detachable open structures, making the installation of the high voltage module TR1, low voltage module TR2, and second shell 20A simpler and more convenient.

In the embodiments shown in FIGS. 19A to 19B, for example, the inner shielding layer IS may be a high voltage shielding layer and the outer shielding layer OS may be a low voltage shielding layer. The inner shielding layer IS as the high voltage shielding layer may be "disposed on a solid insulation surface" (for example, disposed on the inner surface of the first cavity R1), or "disposed inside a solid insulation" (for example, disposed inside the solid insulation near the first cavity R1, similar to the structure shown in FIG. 10). Of course, it may be understood that in other embodiments, the high voltage shielding layer at different positions may adopt different combinations of structures that are "disposed on the solid insulation surface" and "disposed inside the solid insulation", but the present disclosure is not specifically limited to it.

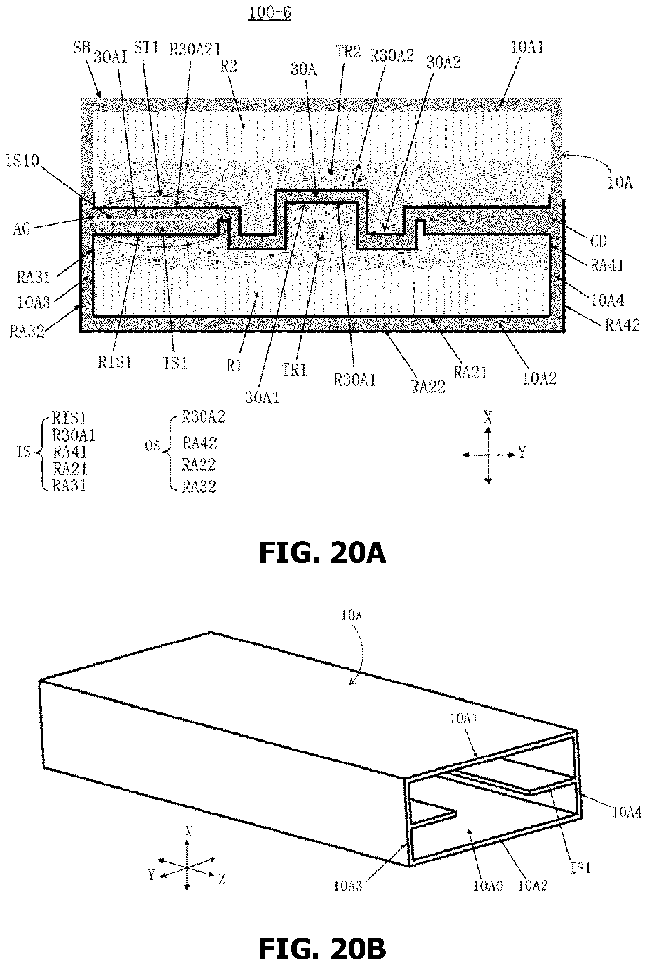

As shown in FIGS. 20A to 20B, FIG. 20A shows the structure of an electronic device including a shielded insulating shell 100-6 according to the fourth preferred embodiment of the present disclosure, and FIG. 20B shows the three-dimensional structure of the first shell 10A of the shielded insulating shell in FIG. 20A. In this embodiment, the shielded insulating shell 100-6 may include the shell body SB and the first structure ST1. The shell body SB may include a first shell 10A and a separator plate 30A. The first shell 10A includes upper wall 10A1 and lower wall 10A2 that are opposite to each other, and two side walls 10A3 and 10A4 that are opposite to each other. The two side walls 10A3 and 10A4 extend inward along the second direction Y (such as the horizontal direction in FIGS. 20A-20B) to form a convex structure, such as the I-shaped plate IS1. The separator plate 30A is installed by fitting to the I-shaped plate IS1, and an internal space 10A0 of the first shell 10A is separated to form the first cavity R1 and the second cavity R2. After the separator plate 30A is installed by fitting to the I-shaped plate IS1, a gap IS10 is formed.

In this embodiment, the two side walls 10A3 and 10A4 of the first shell 10A are provided with first side wall shielding layers RA31 and RA41 disposed near the first cavity R1, for example, on the inner surface corresponding to the first cavity R1. The two side walls 10A3 and 10A4 of the first shell 10A are provided with second side wall shielding layers RA32 and RA42 far away from the first cavity R1, for example, arranged on the outer surface corresponding to the first cavity R1. The lower wall 10A2 of the first shell 10A is provided with an inner lower wall shielding layer RA21 disposed near the first cavity R1, for example, on the inner surface corresponding to the first cavity R1. The lower wall 10A2 of the first shell 10A is provided with an outer lower wall shielding layer RA22 far away from the first cavity R1, for example, arranged on the outer surface corresponding to the first cavity R1. Each I-shaped plate IS1 is provided with a first I-shaped plate shielding layer RIS 1 disposed near the first cavity R1, for example, on the outer surface corresponding to the first cavity R1. The separator plate 30A is provided with a first separator plate shielding layer R30A1 disposed near the first cavity R1, for example, on an inner surface that is positioned correspondingly on the inner side of the first cavity R1, and a second separator plate shielding layer R30A2 disposed far away from the first cavity R1, for example, on an outer surface that is positioned correspondingly on the outer side of the first cavity R1.

In this embodiment, the first I-shaped plate shielding layer RIS1, the I-shaped plate IS1, the gap IS10 formed by fitting and installing the separator plate 30A and the I-shaped plate IS1, the installation portion 30AI for fitting and installing the separator plate 30A and the I-shaped plate IS1, and a partial shielding layer R30A2I of the installation portion 30AI that corresponds to the second separator plate shielding layer R30A2 form, respectively, the first shielding layer and the first insulating layer, the first air gap layer, the second insulating layer, and the second shielding layer of the first structure ST1 correspondingly.

In this embodiment, the first I-shaped plate shielding layer RIS1, the first separator plate shielding layer R30A1, the first side wall shielding layers RA41 and RA31, and the inner lower wall shielding layer RA21 form the inner shielding layer IS correspondingly. The second separator plate shielding layer R30A2, the second side wall shielding layers RA42 and RA32, and the outer lower wall shielding layer RA22 form the outer shielding layer OS correspondingly.

Preferably, in some embodiments of the present disclosure, the separator plate 30A may be installed on the I-shaped plate IS1 by attaching its two ends to the I-shaped plate IS1. In addition, for the convenience of installation, some auxiliary position-limiting structures, including but not limited to stop blocks, may be provided on the I-shaped plate IS 1 to limit the position during the attaching and installation of the separator plate 30A, so that the first air gap layer may be formed correspondingly in the first structure ST1 after the insertion and installation of the separator plate 30A, thereby constructing a sufficient creepage distance by utilizing the first air gap layer. In addition, in some embodiments, the position limitation during the insertion and installation of the separator plate 30A may be implemented by using the high voltage module in the first cavity.

In this embodiment, as shown in FIG. 20A, the gap portion formed between the two ends of the installed separator plate 30A and the inner surfaces of the two side walls 10A3 and 10A4 of the first shell 10A may be regarded as the assembling gap AG. This assembling gap AG may be combined with the first air gap layer (such as the gap IS10 formed correspondingly by the installed separator plate 30A) to form a creepage path on the first structure ST1 that extends from the inner shielding layer IS to the outer shielding layer OS. For example, the space through which the creepage distance CD extends as shown by the dashed line in FIG. 20A is the creepage path.

Preferably, in some embodiments of the present disclosure, concave portions 30A1 and/or 30A2 may be further formed on the separator plate 30A, and may be adapted to part of the outer contours of some devices or modules accommodated correspondingly in the first cavity R1 and/or the second cavity R2, respectively, for example, for disposing the primary and secondary magnetic cores of a transformer. In this embodiment, the electronic device may be a power module, but the present disclosure is not limited to this. For example, the first cavity R1 may be used for accommodating the high voltage module TR1 while the second cavity R2 may be used for accommodating the low voltage module TR2, but the present disclosure is not limited to this.

Preferably, in some embodiments of the present disclosure, two adjacent shielding layers of multiple shielding layers (such as RIS1, R30A1, RA41, RA21, RA31) which form the inner shielding layer IS are connected directly, or connected through conductive tapes or metal plates.

Preferably, in some embodiments of the present disclosure, the first shell 10A and the separator plate 30A may be made of insulating materials, such as but not limited to epoxy resin, polyurethane, or silicone rubber.

Preferably, in some embodiments of the present disclosure, for example, the first shell 10A may be integrally formed.

For the shielded insulating shell 100-6 shown in FIGS. 20A to 20B, the installation process may include fixing the high voltage module TR1 and the low voltage module TR2 onto the separator plate 30A, but not limited thereto in the present disclosure, and then inserting and attaching them to the I-shaped plate IS1 in the third direction Z, thereby fixing them on the first shell 10A. In this embodiment, the separator plate 30A and the first shell 10A are open structures which are detachable, allowing the high voltage module TR1 and low voltage module TR2 to be vertically installed on the separator plate 30A, making installation simpler and more convenient. Compared with the U-shaped groove structure US shown in FIGS. 18A to 18B, the single-plate I-shaped plate IS1 shown in FIGS. 20A to 20B makes it easier to insert the separator plate 30A into the first shell 10A.

In the embodiments shown in FIGS. 20A to 20B, for example, the inner shielding layer IS may be a high voltage shielding layer, and the outer shielding layer OS may be a low voltage shielding layer. The inner shielding layer IS as the high voltage shielding layer may be "disposed on the solid insulation surface" (for example, disposed on the inner surface of the first cavity R1), or "disposed inside the solid insulation" (for example, disposed inside the solid insulation near the first cavity R1, similar to the structure shown in FIG. 10). Of course, it may be understood that in other embodiments, the high voltage shielding layer at different positions may adopt different combinations of structures that are "disposed on the solid insulation surface" and "disposed inside the solid insulation", but the present disclosure is not specifically limited to it.

It may be understood that the shielded insulating shell 100-6 with the I-shaped plate IS1 as the convex structure in FIGS. 20A~20B may be provided only the first cavity R1, like the shielded insulating shell 100-5 with the U-shaped groove US as the convex structure in FIGS. 19A~19B, or may be provided with both the first cavity R1 and the second cavity R2, and the shell body SB may be formed by assembling the detachable first shell 10A and the second shell 20A, but the present disclosure is not specifically limited to it.

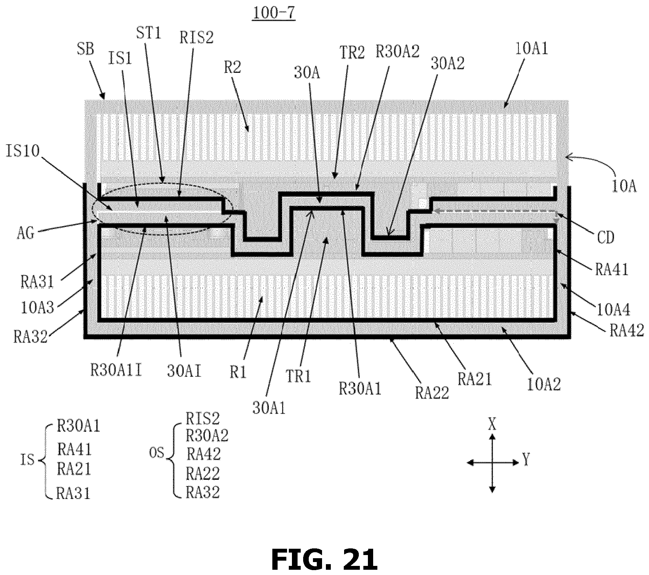

As shown in FIG. 21, FIG. 21 is a structural schematic diagram of an electronic device including a shielded insulating shell 100-7 according to the fifth preferred embodiment of the present disclosure. In this embodiment, the structure of the shielded insulating shell 100-7 is similar to that of the shielded insulating shell 100-6 in FIGS. 20A-20B, except that in the shielded insulating shell 100-6, the separator plate 30A is installed on the I-shaped plate IS1 by attaching its two ends to the I-shaped plate IS1, and on the other hand, in the shielded insulating shell 100-7, the separator plate 30A is installed below the I-shaped plate IS1 by attaching its two ends to the I-shaped plate IS1, to form a gap IS10 correspondingly after fitting and installing the separator plate 30A and I-shaped plate IS1. Each I-shaped plate IS1 is provided with a second I-shaped plate shielding layer RIS2 far away from the first cavity R1. The separator plate 30A is provided with a first separator plate shielding layer R30A1 near the first cavity R1 and a second separator plate shielding layer R30A2 far away from the first cavity. A partial shielding layer R30A1I of the first separator plate shielding layer R30A1 that corresponds to the I-shaped plate, the installation portion 30AI for fitting and installing the separator plate 30A and the I-shaped plate IS1, the gap IS10 formed formed by fitting and installing the separator plate 30A and the I-shaped plate IS1, the I-shaped plate IS1, and the second I-shaped plate shielding layer RIS2 form, respectively, the first shielding layer, first insulating layer, first air gap layer, the second insulating layer, and the second shielding layer of the first structure ST1 correspondingly. The first separator plate shielding layer R30A1, the first side wall shielding layers RA41 and RA31, and the inner lower wall shielding layer RA21 form the inner shielding layer IS correspondingly. Two adjacent shielding layers of multiple shielding layers which form the inner shielding layer IS are connected directly, or connected through conductive tapes or metal plates. The second I-shaped plate shielding layer RIS2, the second separator plate shielding layer R30A2, the second side wall shielding layers RA42 and RA32, and the outer lower wall shielding layer RA22 form the outer shielding layer OS correspondingly.

In this embodiment, as shown in FIG. 21, the gap portion formed between the two ends of the installed separator plate 30A and the inner surfaces of the two side walls 10A3 and 10A4 of the first shell 10A may be regarded as the assembling gap AG. This assembling gap AG be combined with the first air gap layer (such as the gap IS 10 formed correspondingly by the installed separator plate 30A) to form a creepage path on the first structure ST1 that extends from the inner shielding layer IS to the outer shielding layer OS. For example, the space through which the creepage distance CD extends as shown by the dashed line in FIG. 21 is the creepage path.

It should be noted that for the shielded insulating shell disclosed in the present disclosure, the so-called "upper wall" and "lower wall" refer to spatial relative terminology for defining relative relationships between one component or feature and another component or feature as illustrated in the attached drawings. In addition to the orientation depicted in the accompanying drawings, the spatial relative term is also intended to cover different orientations of the device in use, that is, the device may be oriented in other ways.

The advantages of the present disclosure are as follows. (1) The shielded insulating shell of the present disclosure may be constructed with an increased creepage distance by utilizing the first structure formed by assembly, such as through the air gap in the first structure the creepage distance may be sufficiently constructed through the air gap formed by the first shell and the second shell, so that the number of shell components is small and the structure is simple. There may be a plurality of air gaps along the horizontal direction to further increase the creepage distance Thereby reducing the probability of insulation failure; if the system voltage is 10kV, the creepage distance shall not be less than 106mm. (2) The air gap is disposed between the high voltage shielding layer HSL and the low voltage shielding layer LSL, which increases the spacing between the high and low voltage shielding layers, reduces the electric field stress in the air near the edge of the high voltage shielding layer, improves the partial discharge level of the insulating shell, and enhances the electrical performance yield of the shell. (3) the electrical clearance distance and creepage distance may be further increased by provision of an independent insulating layer.

Exemplary embodiments of the present disclosure have been specifically shown and described above. It should be understood that, the present disclosure is not limited to the disclosed embodiments. On the contrary, the present disclosure is intended to cover various modifications and equivalent arrangements included in the scope of the appended claims.

**Claims**

1. A shielded insulating shell (100), comprising:

    a shell body (SB) provided with a first cavity (R1), with an inner shielding layer (IS) near the first cavity (R1) and an outer shielding layer (OS) far away from the first cavity (R1) being formed on the shell body (SB);
    a first structure (ST1) formed on the first cavity (R1), and formed by assembling to comprise at least a first shielding layer, a first insulating layer, a first air gap layer, a second insulating layer, and a second shielding layer arranged sequentially from an inner side to an outer side of the first cavity (R1); and
    an assembling gap (AG) formed on the first structure (ST1), which cooperates with the first air gap layer to form a creepage path on the first structure (ST1) that extends from the inner shielding layer (IS) to the outer shielding layer (OS).

2. The shielded insulating shell (100) according to claim 1, wherein the shell body (SB) comprises a first shell (10) and a second shell (20),

    wherein the first shell (10) comprises a first plate-like structure (11) and at least two first bosses (12) respectively disposed on two opposite sides of the first plate-like structure (11) and extending along a first direction;
    the second shell (20) comprises a second plate-like structure (21) and at least two second bosses (22) respectively disposed on two opposite sides of the second plate-like structure (21) and extending along the first direction;
    the first shell (10) and the second shell (20) are fitted and connected to form a first cavity (R1) through the at least two first bosses (12) and the at least two second bosses (22), wherein an upper wall (R11) of the first cavity (R1) is formed by the first plate-like structure (11) and comprises two upper wall shielding layers (R111, R112) and an upper wall insulating layer (R113) between the two upper wall shielding layers (R111, R112), and a lower wall (R12) of the first cavity (R1) is formed by the second plate-like structure (21) and comprises two lower wall shielding layers (R121, R122) and a lower wall insulating layer (R123) between the two lower wall shielding layers (R121, R122);
    two side walls (R13) of the first cavity (R1) are disposed between the upper wall (R11) and the lower wall (R12) and are respectively formed by the first boss (12) and the second boss (22) which are correspondingly fitted and connected, each of the side walls (R13) comprising, from inside to outside, a first side wall shielding layer (R131), a first side wall insulating layer (R132), a first side wall air gap layer (R133), a second side wall insulating layer (R134) and a second side wall shielding layer (R135);
an inner upper wall shielding layer (R111) of the two upper wall shielding layers (R111, R112) that is disposed on the inner side, an inner lower wall shielding layer (R121) of the two lower wall shielding layers (R121, R122) that is disposed on the inner side, and the first side wall shielding layer (R131) form the inner wall shielding layer correspondingly; and
an outer upper wall shielding layer (R112) of the two upper wall shielding layers (R111, R112) that is disposed on the outer side, an outer lower wall shielding layer (R122) of the two lower wall shielding layers (R121, R122) that is disposed on the outer side, and the second side wall shielding layer (R135) form the outer shielding layer (OS) correspondingly;
wherein the top surface of the first side wall air gap layer is a part of the first shell, and the bottom surface of the first side wall air gap layer is a part of the second shell.

3. The shielded insulating shell (100) according to claim 2, wherein at least a boss interface flush structure is formed at a position where the at least two first bosses (12) and the at least two second bosses (22) are fitted and connected to each other;

each side or one side of the two sides of the first shell (10) comprises two first bosses (12a, 12b), and each side or one side of the two sides of the second shell (20) comprises two second bosses (22a, 22b), whereof the two first bosses (12a, 12b) and the two second bosses (22a, 22b) on each side or the one side are jointed to form two boss interfaces (I1a, I1b) which are disposed at the same height,
wherein the two boss interfaces (I1a, I1b) are centrally disposed on a middle plane (T133, B133) between the top surface and the bottom surface of the first side wall air gap layer (R133).

4. The shielded insulating shell (100) according to claim 2, wherein at least a boss interface staggered structure is formed at a position where the at least two first bosses (12a, 12b) and the at least two second bosses (22a, 22b) are fitted and connected to each other.

5. The shielded insulating shell (100) according to claim 2, wherein at least a boss encapsulation structure is formed at a position where the at least two first bosses (12a, 12b) and the at least two second bosses (22a, 22b) are fitted and connected to each other.

6. The shield insulating shell (100) according to claim 2, wherein each of the side walls (R13) of the first cavity (R1) comprises at least one of the first bosses (12a, 12b) and at least one of the second bosses (22a, 22b), wherein one of the first boss (12a, 12b) and the second boss (22a, 22b) that is disposed on the innermost side is set as an innermost boss, wherein,

the first side wall shielding layer (R131) is disposed on an inner surface of the innermost boss; or
the first side wall shielding layer (R131) is disposed inside the innermost boss, wherein
a further upper wall insulating layer (R114) is formed on the inner surface of the inner upper wall shielding layer (R111); and/or
a further lower wall insulating layer (R124) is formed on the inner surface of the inner lower wall shielding layer (R121); and
an upper side and/or a lower side of at least part of the second plate-like structure (21) of the second shell (20) forms a concave portion (215, 216) for disposing a primary magnetic core (41) and a secondary magnetic core (42) of a transformer, wherein the two lower wall shielding layers (R121, R122) corresponding to the concave portion (215, 216) are semiconductive layers;
and
the shielding layers of the two upper wall shielding layers (R111, R112), the two lower wall shielding layers (R121, R122), the first side wall shielding layer (R131), and the second side wall shielding layer (R135) are perforated plate-like structures or non-perforated plate-like structures;
and
a medium in the first side wall air gap layer (R133) is air, sulfur hexafluoride gas or insulating oil; and/or, the shielded insulating shell (100) is of a detachable structure in which the first shell (10) and the second shell (20) are connected and assembled through a detachable connector,
wherein a lower side of the lower wall (R12) of the first cavity (R1) is further provided with at least two third bosses (23), wherein the at least two third bosses (23) and the lower wall (R12) of the first cavity (R1) form a second cavity (R2); and

the first cavity (R1) is used to accommodate a high voltage module (HVM), and the second cavity (R2) is used to accommodate a lower voltage module (LVM), and

the shielded insulating shell (100) further comprises a high voltage shielding layer (HSL) and a low voltage shielding layer (LSL),

wherein the position of the high voltage shielding layer (HSL) comprises all surfaces immediately adjacent to the high voltage module (HVM), and

the position of the low voltage shielding layer (LSL) comprises all surfaces immediately adjacent to a low voltage module (LVM).

7.  The shielded insulating shell (100, 100-1, 100-2, 100-3) according to claim 2, wherein

the first shell (10) further comprises at least a first intermediate boss (161) disposed between the at least two first bosses (12); and/or,

the second shell (20) further comprises at least a second intermediate boss (261) disposed between the at least two second bosses (22),

wherein the at least a first intermediate boss (161) and/or the at least a second intermediate boss (261) form at least a first intermediate isolation portion which separates the first cavity (R1) into at least two first sub-cavities.

8.  The shielded insulating shell (100, 100-1, 100-2, 100-3) according to claim 7, wherein

the at least a first intermediate isolation portion comprises a first isolation structure (60-1) which is formed by disposing one first intermediate boss (161) to be opposite to one second intermediate boss (261), wherein the first intermediate boss (161) and the second intermediate boss (261) for forming the first isolation structure (60-1) being in contact with each other or separated from each other; and,

the at least a first intermediate isolation portion comprises a second isolation structure (60-2), which is any one of, or a combination of some of, an intermediate boss interface flush structure, an intermediate boss interface staggered structure and an intermediate boss encapsulation structure;

9.  The shielded insulating shell (100, 100-4) according to claim 1, wherein

the shell body (SB) comprises a first shell (10, 10A) and a separator plate (30A);

the first shell (10, 10A) comprises a lower wall (10A2) and two side walls (10A3, 10A4) disposed on opposite sides of the lower wall (10A2) and extending in the first direction, the two side walls (10A3, 10A4) extending inward in a second direction to form a convex structure, and the separator plate (30A) being installed by fitting to the convex structure to form the first structure (ST1) and forming the first cavity (R1) with the first shell (10, 10A).

10. The shielded insulating shell (100, 100-4) according to claim 9, wherein

the first shell (10, 10A) further comprises an upper wall (10A1) opposite to the lower wall (10A2), and the separator plate (30A) is installed by fitting to the convex structure to separate an internal space (10A0) of the first shell (10, 10A) to form the first cavity (R1) and a second cavity (R2); and

the first shell (10, 10A) is integrally formed.

11. The shielded insulating shell (100, 100-4) according to claim 9, wherein

the shell body (SB) further comprises a second shell (20, 20A);

the second shell (20, 20A) comprises an upper wall (20A1) and two side walls (20A3, 20A4) disposed on opposite sides of the upper wall (20A1) and extending in the first direction, the first shell (10, 10A) and the second shell (20, 20A) being fitted and connected in a detachable manner;

the two side walls (10A3, 10A4) of the first shell (10, 10A) and the two side walls (20A3, 20A4) of the second shell (20, 20A) are fitted and connected in an opposite way in the first direction to form an internal space; the separator plate (30A) separates the internal space to form the first cavity (R1) and a second cavity (R2); and

the first shell (10, 10A) is integrally formed, and the second shell (20, 20A) is integrally formed.

12. The shielded insulating shell (100, 100-5) according to claim 9, wherein

a concave part is further formed on the separator plate (30A); and

the convex structure is a U-shaped groove structure (US), each U-shaped groove structure (US) comprising two groove walls (US1, US3) that are opposite to each other and a groove (US2) disposed between the two groove walls (US1, US3);

the separator plate (30A) is installed in the U-shaped groove structure (US) by inserting its two ends in the U-shaped groove structure (US), without providing the shielding layer on the inserted parts of the two ends of the separator plate (30A);

the two side walls (10A3, 10A4) of the first shell (10, 10A) are provided with first side wall shielding layers (RA31, RA41) disposed near the first cavity (R1) and second side wall shielding layers (RA32, RA42) disposed far away from the first cavity (R1);

the lower wall (10A2) of the first shell (10, 10A) is provided with an inner lower wall shielding layer (RA21) disposed near the first cavity (R1) and an outer lower wall shielding layer (RA22) disposed far away from the first cavity (R1);

a first groove wall (US1) of the two groove walls (US1, US3) of each U-shaped groove structure (US) that is positioned correspondingly on the inner side of the first cavity (R1) is provided with a first groove wall shielding layer (RST1) disposed near the first cavity (R1);

a second groove wall (US3) of the two groove walls (US1, US3) of each U-shaped groove structure (US) that is positioned correspondingly on the outer side of the first cavity (R1) is provided with a second groove wall shielding layer (RST2) disposed far away from the first cavity (R1);

the separator plate (30A) is provided with a first separator plate shielding layer (R30A1) disposed near the first cavity (R1) and a second separator plate shielding layer (R30A2) disposed far away from the first cavity (R1);

the first groove wall shielding layer (RST1), the first groove wall (US1) of the U-shaped groove structure (US), the gap portion remained in the groove (US2) of the inserted U-shaped groove structure (US), the second groove wall (US3) of the U-shaped groove structure (US), and the second groove wall shielding layer (RST2) form, respectively, the first shielding layer, the first insulating layer, the first air gap layer, the second insulating layer, and the second shielding layer of the first structure (ST1) correspondingly;

the first groove wall shielding layer (RST1), the first separator plate wall shielding layer (R30A1), the first side wall shielding layer (RA41, RA31), and the inner lower wall shielding layer (RA21) form the inner shielding layer (IS) correspondingly, two adjacent shielding layers of multiple shielding layers (RST1, R30A1, RA41, RA31, RA21) which form the inner shielding layer (IS) being connected directly, or connected through conductive tapes or metal plates; and

the second groove wall shielding layer (RST2), the second separator plate shielding layer (R30A2), the second side wall shielding layer (RA42, RA32), and the outer lower wall shielding layer (RA22) form the outer shielding layer (OS) correspondingly,

wherein

the first side wall shielding layer (RA31, RA41) is disposed on the inner surface of the two side walls (10A3, 10A4) of the first shell (10, 10A) that corresponds to the first cavity (R1);

the second side wall shielding layer (RA32, RA42) is disposed on the outer surface of the two side walls (10A3, 10A4) of the first shell (10, 10A) that corresponds to the first cavity (R1);

the inner lower wall shielding layer (RA21) is disposed on the inner surface of the lower wall (10A2) of the first shell (10, 10A) that corresponds to the first cavity (R1);

the outer lower wall shielding layer (RA22) is disposed on the outer surface of the lower wall (10A2) of the first shell (10, 10A) that corresponds to the first cavity (R1);

the first groove wall shielding layer (RST1) is disposed on the outer surface of the first groove wall (US1) of the U-shaped groove structure (US);

the second groove wall shielding layer (RST2) is disposed on the outer surface of the second groove wall (US3) of the U-shaped groove structure (US);

the first separator plate shielding layer (R30A1) is disposed on the inner surface of the separator plate (30A) that corresponds to the inner side of the first cavity (R1); and

the second separator plate shielding layer (R30A2) is disposed on the outer surface of the separator plate (30A) that corresponds to the outer side of the first cavity (R1).

13. The shielded insulating shell (100, 100-6) according to claim 9, wherein

the convex structure is an I-shaped plate (IS1), the separator plate (30A) being installed on the I-shaped plate (IS1) by attaching its two ends to the I-shaped plate (IS1), and a gap (IS10) being formed by fitting and installing the separator plate (30A) and the I-shaped plate (IS1);

the two side walls (10A3, 10A4) of the first shell (10, 10A) are provided with a first side wall shielding layer (RA31, RA41) disposed near the first cavity (R1) and a second side wall shielding layer (RA32, RA42) disposed far away from the first cavity (R1);

the lower wall (10A2) of the first shell (10, 10A) is provided with an inner lower wall shielding layer (RA21) disposed near the first cavity (R1) and an outer lower wall shielding layer (RA22) disposed far away from the first cavity (R1);

each I-shaped plate (IS1) is provided with a first I-shaped plate shielding layer (RIS1) disposed near the first cavity (R1);

the separator plate (30A) is provided with a first separator plate shielding layer (R30A1) disposed near the first cavity (R1) and a second separator plate shielding layer (R30A2) disposed far away from the first cavity (R1);

the first I-shaped plate shielding layer (RIS1), the I-shaped plate (IS1), the gap (IS10) formed by fitting and installing the separator plate (30A) and the I-shaped plate (IS1), the installation portion (30AI) for fitting and installing the separator plate (30A) and the I-shaped plate (IS1), and a partial shielding layer (R30A2I) of the installation portion (30AI) that corresponds to the second separator plate shielding layer (R30A2) form, respectively, the first shielding layer, the first insulating layer, the first air gap layer, the second insulating layer and the second shielding layer of the first structure (ST1) correspondingly;

the first I-shaped plate shielding layer (RIS1), the first separator plate shielding layer (R30A1), the first side wall shielding layer (RA41, RA31), and the inner lower wall shielding layer (RA21) form at least a part of the inner shielding layer (IS) correspondingly, two adjacent shielding layers of multiple shielding layers (RIS1, R30A1, RA41, RA21, RA31) which form the inner shielding layer (IS) being connected directly, or connected through conductive tapes or metal plates; and

the second separator plate shielding layer (R30A2), the second side wall shielding layer (RA42, RA32), and the outer lower wall shielding layer (RA22) form the outer shielding layer (OS) correspondingly.

**14.** The shielded insulating shell (100, 100-7) according to claim 9, wherein

the convex structure is an I-shaped plate (IS1), the separator plate (30A) being installed below the I-shaped plate (IS1) by attaching its two ends to the I-shaped plate (IS1), and a gap (IS10) being formed by fitting and installing the separator plate (30A) and the I-shaped plate (IS1);

the two side walls (10A3, 10A4) of the first shell (10, 10A) are provided with a first side wall shielding layer (RA41, RA31) disposed near the first cavity (R1) and a second side wall shielding layer (RA42, RA32) disposed far away from the first cavity (R1);

the lower wall (10A2) of the first shell (10, 10A) is provided with an inner lower wall shielding layer (RA21) disposed near the first cavity (R1) and an outer lower wall shielding layer (RA22) disposed far away from the first cavity (R1);

each I-shaped plate (IS1) is provided with a second I-shaped plate shielding layer (RIS2) disposed far away the first cavity (R1);

the separator plate (30A) is provided with a first separator plate shielding layer (R30A1) disposed near the first cavity (R1) and a second separator plate shielding layer (R30A2) disposed far away from the first cavity (R1);

a partial shielding layer (R30A1I) of the first separator plate shielding layer (R30A1) that corresponds to the I-shaped plate (IS1), the installation portion (30AI) for fitting and installing the separator plate (30A) and the I-shaped plate (IS1), the gap (IS10) formed by fitting and installing the separator plate (30A) and the I-shaped plate (IS1), the I-shaped plate (IS1), and the second I-shaped plate shielding layer (RIS2) form, respectively, the first shielding layer, the first insulating layer, the first air gap layer, the second insulating layer, and the second shielding layer of the first structure (ST1) correspondingly;

the first separator plate shielding layer (R30A1), the first side wall shielding layers (RA41, RA31), and the inner lower wall shielding layer (RA21) form the inner shielding layer (IS) correspondingly, two adjacent shielding layers of multiple shielding layers which form the inner shielding layer (IS) being connected directly, or connected through conductive tapes or metal plates; and

the second I-shaped plate shielding layer (RIS2), the second separator plate shielding layer (R30A2), the second side wall shielding layers (RA42, RA32), and the outer lower wall shielding layer (RA22) form the outer shielding layer (OS) OS correspondingly.

**15.** An electronic device, comprising:

a shielded insulating shell (100), comprising:

a shell body (SB) provided with a first cavity (R1), with an inner shielding layer (IS) near the first cavity (R1) and an outer shielding layer (OS) far away from the first cavity (R1) being formed on the shell body (SB);

a first structure (ST1) formed on the first cavity (R1), and formed by assembling to comprise at least a first shielding layer, a first insulating layer, a first air gap layer, a second insulating layer, and a second shielding layer arranged sequentially from an inner side to an outer side of the first cavity (R1); and

an assembling gap (AG) formed on the first structure (ST1), which cooperates with the first air gap layer to form a creepage path on the first structure (ST1) that extends from the inner shielding layer (IS) to the outer shielding layer (OS); and

a high voltage module (HVM), which is accommodated in the first cavity (R1) of the shielded insulating shell (100).

16. The electronic device according to claim 15, wherein the electronic device further comprises:

a low voltage module (LVM) which is accommodated in a second cavity (R2) of the shielded insulating shell (100), wherein the electronic device further comprises:

a transformer (T),
wherein primary magnetic core (41) and a secondary magnetic core (42) of the transformer (T) are disposed on two sides of a concave portion (215, 216) formed on at least a partial plate-like structure of a second plate-like structure (21) of a second shell (20) of the shielded insulation shell, or the primary magnetic core (41) and the secondary magnetic core (42) of the transformer (T) are disposed on two sides of a concave portion (215, 216) formed on a separator plate (30A) of the shielded insulation shell (100),
wherein
the first shell (10) of the shielded insulating shell (100) further comprises at least a first intermediate boss (161) disposed between at least two first bosses (12);
the second shell (20) of the shielded insulating shell (100) further comprises at least a second intermediate boss (261) disposed between the at least two second bosses (22);
wherein a first intermediate isolation portion is formed by the at least a first intermediate boss (161) and/or the at least a second intermediate boss (261), for separating the first cavity (R1) into at least two first sub-cavities, wherein at least a high voltage module (HVM) is disposed in each of the first sub-cavities;
at least a low voltage module (LVM) is disposed in the at least a second cavity (R2).

**FIG. 1**

**FIG. 2A**

**FIG. 2B**

**FIG. 2C**

$IS \begin{cases} R111 \\ R121 \\ R131 \end{cases}$ $OS \begin{cases} R112 \\ R122 \\ R135 \end{cases}$ $R134 \begin{cases} 12a \\ 22a \end{cases}$ $R132 \begin{cases} 12b \\ 22b \end{cases}$

**FIG. 3**

# FIG. 4A

# FIG. 4B

**FIG. 5**

**FIG. 6A**

**FIG. 6B**

**FIG. 6C**

**FIG. 6D**

**FIG. 7A**

**FIG. 7B**

**FIG. 7C**

R133

11 I9b 12a I9a

ED CD

22a

21

22b

23

**FIG. 7D**

R133 10

12a $d_{a1}$ $d_{a2}$ 12b 22b R1 E1 $d_{12}$

$d_{R13}$ HVM E2

$d_{s1}$ $d_{s2}$ $d_{s3}$

LVM

CD

23 22a 20 R2

**FIG. 8**

**FIG. 9**

**FIG. 10**

EP 4 312 474 A1

R133

R135 (LSL)
R131 (HSL)
12b

CD

HVM

ED
30
22b

**FIG. 11A**

CD

ED

HVM

30

R133

**FIG.11B**

46

**FIG. 12**

**FIG. 13A**

**FIG. 13B**

FIG 14

FIG 15A

**FIG 15B**

FIG 15C

HVM-a1 HVM-a2 HVM-b1 HVM-b2 HVM-c1 HVM-c2

R1

**FIG 16A**

**FIG. 16B**

# FIG. 17

# FIG. 18A

**FIG. 18B**

100-5

IS $\left\{\begin{array}{l} \text{RST1} \\ \text{R30A1} \\ \text{RA41} \\ \text{RA21} \\ \text{RA31} \end{array}\right.$    OS $\left\{\begin{array}{l} \text{RST2} \\ \text{R30A2} \\ \text{RA42} \\ \text{RA22} \\ \text{RA32} \end{array}\right.$

**FIG. 19A**

**FIG. 19B**

100-6

**FIG. 20A**

**FIG. 20B**

100-7

**FIG. 21**

# EUROPEAN SEARCH REPORT

Application Number

EP 23 18 7235

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | WO 2021/157205 A1 (DENSO CORP)<br>12 August 2021 (2021-08-12)<br>* paragraph [0015] - paragraph [0017] *<br>* paragraph [0020] - paragraph [0021] *<br>* paragraph [0024] - paragraph [0028] *<br>* paragraph [0046] *<br>* paragraph [0068] - paragraph [0071] *<br>* figure 7 * | 1,9-11,<br>15,16<br>2-8,<br>12-14 | INV.<br>H05K7/14<br>H05K9/00<br>H02M7/00 |
| A | US 2018/295756 A1 (HIROSE TATSUYA [JP])<br>11 October 2018 (2018-10-11)<br>* paragraph [0035] - paragraph [0037] *<br>* paragraph [0061] - paragraph [0062] *<br>* paragraph [0068] - paragraph [0069] *<br>* paragraph [0073] - paragraph [0074] *<br>* paragraph [0080] - paragraph [0081] *<br>* paragraph [0085] *<br>* paragraph [0101] - paragraph [0107] *<br>* paragraph [0122] - paragraph [0125] *<br>* figures 1-4.9-11,14-16 * | 1-16 | |
| A | US 2018/153046 A1 (XIE YICONG [CN] ET AL)<br>31 May 2018 (2018-05-31)<br>* paragraph [0025] - paragraph [0035] *<br>* paragraph [0047] - paragraph [0051] *<br>* figures 1-9 * | 1-16 | TECHNICAL FIELDS<br>SEARCHED (IPC)<br><br>H05K<br>H02M |
| A | EP 4 009 753 A1 (DELTA ELECTRONICS<br>SHANGHAI CO [CN]) 8 June 2022 (2022-06-08)<br>* paragraph [0004] *<br>* paragraph [0029] - paragraph [0032] *<br>* paragraph [0037] - paragraph [0038] *<br>* paragraph [0042] *<br>* figures 1-5 * | 1-16 | |

-/--

The present search report has been drawn up for all claims

| Place of search | Date of completion of the search | Examiner |
|---|---|---|
| The Hague | 13 December 2023 | Jorna, Pieter |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

........................................................................
& : member of the same patent family, corresponding
    document

EPO FORM 1503 03.82 (P04C01)

Europäisches
Patentamt
European
Patent Office
Office européen
des brevets

# EUROPEAN SEARCH REPORT

Application Number

EP 23 18 7235

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2018/048244 A1 (JACOBSON BORIS S [US] ET AL) 15 February 2018 (2018-02-15)<br>* paragraph [0005] *<br>* paragraph [0021] *<br>* paragraph [0027] – paragraph [0032] *<br>* paragraph [0040] – paragraph [0041] *<br>* figures 1-4 * | 1-16 | |
| A | US 6 265 656 B1 (BERTH MATTHIAS [CH]) 24 July 2001 (2001-07-24)<br>* column 2, line 23 – column 6, line 7 *<br>* figures 1-8 * | 1-16 | |
| A | US 2009/146862 A1 (MALONE WILLIAM G [US]) 11 June 2009 (2009-06-11)<br>* paragraph [0020] – paragraph [0021] *<br>* paragraph [0026] – paragraph [0031] *<br>* figures 7-11 * | 1-16 | |

TECHNICAL FIELDS
SEARCHED    (IPC)

The present search report has been drawn up for all claims

| Place of search | Date of completion of the search | Examiner |
|---|---|---|
| The Hague | 13 December 2023 | Jorna, Pieter |

EPO FORM 1503 03.82 (P04C01)

## ANNEX TO THE EUROPEAN SEARCH REPORT
## ON EUROPEAN PATENT APPLICATION NO.

EP 23 18 7235

This annex lists the patent family members relating to the patent documents cited in the above-mentioned European search report.
The members are as contained in the European Patent Office EDP file on
The European Patent Office is in no way liable for these particulars which are merely given for the purpose of information.

13-12-2023

| Patent document cited in search report | | Publication date | Patent family member(s) | | Publication date |
|---|---|---|---|---|---|
| WO 2021157205 | A1 | 12-08-2021 | CN | 115004533 A | 02-09-2022 |
| | | | DE | 112020006679 T5 | 08-12-2022 |
| | | | JP | 7180624 B2 | 30-11-2022 |
| | | | JP | 2021125925 A | 30-08-2021 |
| | | | US | 2022368242 A1 | 17-11-2022 |
| | | | WO | 2021157205 A1 | 12-08-2021 |
| US 2018295756 | A1 | 11-10-2018 | JP | 6985588 B2 | 22-12-2021 |
| | | | JP | 2018181974 A | 15-11-2018 |
| | | | US | 2018295756 A1 | 11-10-2018 |
| US 2018153046 | A1 | 31-05-2018 | CN | 108123617 A | 05-06-2018 |
| | | | US | 2018153046 A1 | 31-05-2018 |
| EP 4009753 | A1 | 08-06-2022 | CN | 114465445 A | 10-05-2022 |
| | | | EP | 4009753 A1 | 08-06-2022 |
| | | | US | 2022149743 A1 | 12-05-2022 |
| US 2018048244 | A1 | 15-02-2018 | AU | 2017308676 A1 | 28-02-2019 |
| | | | CA | 3033367 A1 | 15-02-2018 |
| | | | EP | 3498062 A1 | 19-06-2019 |
| | | | US | 2018048244 A1 | 15-02-2018 |
| | | | US | 2019207529 A1 | 04-07-2019 |
| | | | WO | 2018031389 A1 | 15-02-2018 |
| US 6265656 | B1 | 24-07-2001 | DE | 19841134 A1 | 16-03-2000 |
| | | | EP | 0994642 A2 | 19-04-2000 |
| | | | JP | 2000091127 A | 31-03-2000 |
| | | | US | 6265656 B1 | 24-07-2001 |
| US 2009146862 | A1 | 11-06-2009 | US | 2009146862 A1 | 11-06-2009 |
| | | | US | 2012085576 A1 | 12-04-2012 |

EPO FORM P0459

For more details about this annex : see Official Journal of the European Patent Office, No. 12/82